# EUROPEAN PATENT SPECIFICATION

(11) **EP 4 564 291 B1**
(45) Date of publication and mention of the grant of the patent: **08.07.2026**
(21) Application number: 24160600.3
(22) Date of filing: 29.02.2024
(51) Int. Cl.: G06T 7/62

(54) **AUTOMATED BUILDING DIMENSION DETERMINATION USING ANALYSIS OF ACQUIRED BUILDING IMAGES**
AUTOMATISIERTE GEBÄUDEDIMENSIONSBESTIMMUNG MITTELS ANALYSE VON ERFASSTEN GEBÄUDEBILDERN
DÉTERMINATION AUTOMATISÉE DE DIMENSION DE BÂTIMENT À L'AIDE D'UNE ANALYSE D'IMAGES DE BÂTIMENT ACQUISES

(30) Priority: 01.12.2023 US 202318527073
(43) Date of publication of application: 04.06.2025
(73) Proprietor: MFTB Holdco, Inc., Seattle, Washington 98101 (US)
(72) Inventor: WAN, Zhiqiang, Kirkland, 98033 (US); NARAYANA, Manjunath, Chino Hills, 91709 (US); BHANUSHALI, Jasmine Jayant, Bothell, 98021 (US)
(74) Representative: Reddie & Grose LLP

(56) References cited:
- EP-A1- 4 174 772
- CA-C- 3 058 602
- US-A1- 2021 064 216
- US-A1- 2023 071 446
- US-B2- 11 514 674

## Description

### TECHNICAL FIELD

The following disclosure relates generally to techniques for automatically analyzing visual data of images acquired at a building to determine building information that includes building dimensions and for subsequently using such information in one or more automated manners, such as to determine scale information for building images using visible structural building objects of defined types, to use the image scale information to determine resulting building dimensions for walls and other elements visible in the images (e.g., for use with a floor plan generated from analysis of the images), and to provide navigational data for the building in accordance with the determined building information and by automatically generating descriptions of the similarities.

### BACKGROUND

In various circumstances, such as architectural analysis, property inspection, real estate acquisition and development, general contracting, improvement cost estimation, etc., it may be desirable to know the interior of a house or other building without physically traveling to and entering the building. However, it can be difficult to effectively capture, represent and use such building interior information, including to identify buildings that satisfy criteria of interest, and to display visual information captured within building interiors to users at remote locations (e.g., to enable a user to understand the layout and other details of the interior, including to control the display in user-selected manners). Also, even if a user is present at a building, it can be difficult to effectively navigate the building and determine information about the building that is not readily apparent. While a floor plan of a building may provide some information about layout and other details of a building interior, such use of floor plans has some drawbacks, including that floor plans can be difficult to construct and maintain, to accurately scale and populate with information about room interiors, to visualize and otherwise use, etc.

US2021/064216A1 describes techniques for using computing devices to perform automated operations involved in analysis of images acquired in a defined area, as part of generating mapping information of the defined area for subsequent use (e.g., for controlling navigation of devices, for display on client devices in corresponding GUIs, etc.). The defined area may include an interior of a multi-room building, and the generated information including a floor map of the building, such as from an analysis of multiple 360° spherical panorama images acquired at various viewing locations within the building (e.g., using an image acquisition device with a spherical camera having one or more fisheye lenses to capture a panorama image that extends 360 degrees around a vertical axis)-the generating may be further performed without detailed information about distances from the images' viewing locations to objects in the surrounding building.

US11514674B2 describes techniques for using computing devices to perform automated operations for determining the acquisition location of an image using an analysis of the image's visual contents. In at least some situations, images to be analyzed include panorama images acquired at acquisition locations in an interior of a multi-room building, and the determined acquisition location information includes a location on a floor plan of the building and in some cases orientation direction information-in at least some such situations, the acquisition location determination is performed without having or using information from any distance-measuring devices about distances from an image's acquisition location to objects in the surrounding building. The acquisition location information may be used in various automated manners, including for controlling navigation of devices (e.g., autonomous vehicles), for display on one or more client devices in corresponding graphical user interfaces, etc.

### BRIEF DESCRIPTION OF THE DRAWINGS

Figure 1 includes diagrams depicting an exemplary building interior environment and computing system(s) for use in embodiments of the present disclosure, including to generate and present information representing an interior of the building based in part on determined building dimension data.
Figures 2A-2L illustrate examples of automatically analyzing visual data of images acquired at a building to determine building information that includes building dimensions and for subsequently using such information in one or more automated manners.
Figure 3 is a block diagram illustrating computing systems suitable for executing an embodiment of a system that performs at least some of the techniques described in the present disclosure.
Figure 4 illustrates an example embodiment of a flow diagram for an Image Capture and Analysis (ICA) system routine in accordance with an embodiment of the present disclosure.
Figures 5A-5B illustrate an example embodiment of a flow diagram for a Mapping Information Generation Manager (MIGM) system routine in accordance with an embodiment of the present disclosure.
Figure 6 illustrates an example embodiment of a flow diagram for a Building Object-Based Scale Determination Manager (BOBSDM) system routine in accordance with an embodiment of the present disclosure.
Figure 7 illustrates an example embodiment of a flow diagram for a Building Information Access system routine in accordance with an embodiment of the present disclosure.

### DETAILED DESCRIPTION

The present disclosure describes techniques for using computing devices to perform automated operations involving analyzing visual data of images acquired at a building to determine building information that includes building dimensions, and subsequently using the determined building information in one or more automated manners, such as to provide navigational data for the building in accordance with the building dimensions (*e.g.,* for controlling navigation of mobile devices, such as autonomous vehicles, in the building). The automated determination of building dimensions and other building information may include analyzing visual data of building images to determine an estimated camera height of the camera(s) during capture of the images and other scale information for the images based on identified visible installed building objects of defined types, using the determined image scale information to further determine resulting building dimensions (*e.g.,* lengths of and heights of walls visible in the images, such as to determine room sizes), and optionally associating the building dimension data with a floor plan generated from analysis of the images - such a floor plan may, in at least some embodiments, be for an as-built multi-room building (*e.g.,* a house, office building, etc.) and generated from or otherwise associated with panorama images or other images (*e.g.,* rectilinear perspective images) acquired at acquisition locations in and around the building (*e.g.,* without having or using information from any depth sensors or other distance-measuring devices about distances from an image's acquisition location to walls or other objects in the surrounding building). The determined building information for the building may be further used in various manners, such as to improve automated navigation of the building, for display or other presentation on one or more client devices in corresponding GUIs (graphical user interfaces) to enable virtual navigation of the building, etc. Additional details are included below regarding automated determination and use of building information from analysis of building images, and some or all techniques described herein may, in at least some embodiments, be performed via automated operations of a Building Object-Based Scale Determination Manager ("BOBSDM") system, as discussed further below.

As noted above, automated operations of a BOBSDM system may include analyzing visual data of images acquired at a building to determine building dimensions and other building information. In at least some embodiments, the automated analysis of the visual data of the images acquired at a building includes identifying visible structural objects or other installed objects of one or more defined types at the building that have standardized sizes or otherwise have expected sizes, such as doorways (*e.g.,* with an expected height of 80 inches or 2.03 meters), and/or cabinets positioned on the floor (also referred to herein as 'floor cabinets') (*e.g.,* with an expected height of 36 inches) - in other embodiments, other object types may be used that each have one or a limited quantity of standardized sizes, whether in addition to or instead of doorways and/or floor cabinets, such as one or more of the following: ovens, dishwashers, electrical plates, air outlets, fan blades, beds, televisions, electrical outlets, wall switch plates, etc. As one non-exclusive example, the four corners of a doorway may be identified in an image, the corresponding coordinates of those points within the image may be translated into real-world coordinates using the expected height of 80 inches along the sides of the doorway between pairs of corners, and an estimated height of the camera used to acquire the image may then be determined - for example, for a panorama image in straightened form (with vertical objects in the actual environment, such as the sides of a typical rectangular door frame or a typical border between 2 adjacent walls, being shown vertically in the image, such as in a single pixel column) and in an equirectangular format (*e.g*., with straight vertical object data remaining straight, and with straight horizontal data such as the top of a typical rectangular door frame or a border between a wall and a floor remaining straight at a horizontal midline of the image but being increasingly curved in the equirectangular projection image in a convex manner relative to the horizontal midline as the distance increases in the image from the horizontal midline), the determining of the estimated camera height h1 (in inches) may be performed using the following formula (1): $80 inches divided by 1 + \frac{\sqrt{{\left({x}_{1}-{x}_{2}\right)}^{2} + {\left({z}_{1}-{z}_{2}\right)}^{2}}}{\sqrt{{\left({x}_{3}-{x}_{4}\right)}^{2} + {\left({z}_{3}-{z}_{4}\right)}^{2}}}$ where x1 is the horizontal (left-and-right) position of the lower left corner of the doorway, x2 is the horizontal position of the lower right corner of the doorway, x3 is the horizontal position of the upper left corner of the doorway, x4 is the horizontal position of the upper right corner of the doorway, z1 is the vertical (up- and-down) position of the lower left corner of the doorway, z2 is the vertical position of the lower right corner of the doorway, z3 is the vertical position of the upper left corner of the doorway, and z4 is the vertical position of the upper right corner of the doorway. A similar estimated camera height determination may be performed in a simplified manner for images that are not in equirectangular format (*e.g.,* perspective images in rectilinear format), with formula (1) adjusted to account for the lack of curvature for horizontal data in a perspective images in rectilinear format. Such estimated camera heights may similarly be determined for additional identified doorway objects in the building image(s) (*e.g.,* the same doorway as seen in a different image, a different doorway seen in the same image, a different doorway seen in a different image, etc.), such as for multiple building images captured for a building using the same constant actual camera height above the floor or other underlying surface (*e.g.,* multiple images captured in an image acquisition session by one or more cameras using the same tripod at a fixed height or held by an operator user at a consistent height), and a doorway-based estimated camera height may be determined from one or more individual camera height estimations for the one or more identified doorways (*e.g.,* an aggregated estimated camera height for multiple identified doorways, such as using a mean or other average of individual camera height estimations).

In addition, estimated camera heights may similarly be determined based on one or more identified floor cabinets. As one non-exclusive example, for a floor cabinet identified in an image in straightened format, and for one or some or all pixel columns in the image that include visual data of that floor cabinet, the cabinet bottom (*e.g.,* intersection with the floor) and cabinet top (*e.g.,* top of a countertop or other upper surface of the floor cabinet) are identified. The corresponding coordinates in such a pixel column for the rows of the image that show the cabinet bottom and top may then be translated into real-world coordinates using the expected height of 36 inches between those rows, and an estimated height of the camera used to acquire the image may then be determined for an image (*e.g.,* a panoramic image) in a manner analogous to that discussed above with respect to formula (1) if the image is in equirectangular format, or in an manner adjusted for the lack of curvature of horizontal data for images in non-equirectangular formats. As one non-exclusive example for a straightened panorama image having visual data of a floor cabinet across a sequence of pixel columns, the determining of the estimated camera height h2 (in inches) for each such pixel column may be performed using the following formula (2): $36 inches divided by \left(1-tangent\left(alpha2\right)/tangent\left(alpha1\right)\right)$ where *alpha1* is the angle between a line from the camera center to the cabinet top front edge for that pixel column and a line straight down from the camera center in the direction of gravitational force, and *alpha2* is the angle between a line from the camera center to the cabinet bottom front edge for that pixel column and a line straight down from the camera center in the direction of gravitational force. Such estimated camera heights may similarly be determined for additional identified floor cabinet objects in the building image(s) (*e.g.,* the same cabinet object as seen in a different image, a different cabinet object seen in the same image, a different cabinet object seen in a different image, etc.), such as for multiple building images captured for a building using the same constant actual camera height above the floor or other underlying surface (*e.g.,* multiple images captured in an image acquisition session by one or more cameras using the same tripod at a fixed height or held by an operator user at a consistent height), and an aggregate cabinet-based estimated camera height may be determined from individual camera height estimations for the one or more identified floor cabinets (*e.g*., an aggregated estimated camera height based on multiple individual pixel-column camera height estimations for a single floor cabinet in a single panorama image and/or based on multiple individual pixel-column camera height estimations for multiple identified floor cabinets in one or more panorama images, such as using a mean or other average of the multiple individual camera height estimations).

After such a doorway-based estimated camera height and a cabinet-based estimated camera height are determined for one or more building images acquired at a building (or one or more other camera height estimations based on one or more other object types, whether in addition to or instead of doorway-based ad/or cabinet-based estimated camera heights), the information from the multiple estimated camera heights may be used to determine a final estimated camera height for use with the image(s). In at least some embodiments and situations, the determination of the final estimated camera height for the image(s) may include comparing the multiple estimated camera heights to determine whether they satisfy one or more defined validation criteria (*e.g.,* differ from each other by less than a defined maximum amount, such as a fixed distance, or a percentage, or other relative difference between the smallest and largest of the estimated camera heights, etc.), and if so determining the final estimated camera height for the image(s) from the multiple estimated camera heights (*e.g.,* using a mean or other average, such as a weighted average based on object type and number of instances of an object; selecting a minimum value or maximum value or other representative value; etc.). In other embodiments and situations, a final camera height for a group of one or more building images may instead be determined using a single type of object visible in the image(s).

Once a final camera height is determined for one or more images of a building, that camera height data may be further used to determine additional scaling information for objects and other elements visible in the images, such as building dimensions based at least in part on widths/lengths and/or heights of walls visible in the image(s), widths of doorways and other non-doorway wall openings visible in the image(s), etc., including to determine actual sizes of rooms and/or other areas on a floor plan (rather than merely determining relative room shapes sizes and positions). In addition, such determined camera height data and/or resulting building dimensions may be used in other manners in other embodiments, whether in addition to or instead of determining actual size information for floor plans, such as to determine actual sizes of structural and/or non-structural objects (*e.g.,* for use in remodeling, such as to determine sizes of objects to be replaced, sizes of empty areas in which to add objects, etc.). Additional details are included below related to using the determined final camera height data in various manners, including to determine building dimensions and other building information.

In addition, in at least some embodiments and situations, one or more other techniques may be used to determine a final camera height and/or resulting building dimensions for a group of one or more building images, such as to further validate a final camera height determined using visible objects of one or more determined types (*e.g.,* to confirm that the camera heights from multiple techniques differ from each other by less than a defined maximum amount), or to instead use the one or more other techniques instead of using visible objects of one or more determined types (*e.g.,* if the one or more validation criteria are not satisfied for estimated camera height data using visible objects of one or more determined types). As one non-exclusive example, a floor plan may be generated for a building using images acquired at the building, an exterior of the floor plan may be fitted to an exterior of the building as shown in an overhead image of the building (*e.g.,* an image from a drone, airplane, satellite, etc.), and room dimensions and other building information (including a final camera height for one or more images acquired at the building) may be determined using the fitted floor plan and information about the size of the building exterior in the overhead image (*e.g.,* using GPS data points associated with the overhead image). Additional details are included below related to determining a final camera height for building images using identified structural building objects.

The described techniques provide various benefits in various embodiments, including to allow floor plans of multi-room buildings and other structures to be identified and used more efficiently and rapidly and in manners not previously available, including to automatically determine building dimensions for a building by analyzing visual data of images acquired at the building to identify objects of one or more defined types and to use standardized sizes or otherwise expected sizes of such objects to determine the camera height and other scaling information for the images. In addition, such automated techniques allow such determination of building dimensions and other building information to be determined by using information acquired from the actual building environment (rather than from plans on how the building should theoretically be constructed), as well as enabling the capture of changes to structural elements and/or visual appearance elements that occur after a building is initially constructed. Such described techniques further provide benefits in allowing improved automated navigation of a building by mobile devices (*e.g.,* semi-autonomous or fully autonomous vehicles), based at least in part on the determined building dimensions, including to significantly reduce computing power and time used to attempt to otherwise learn a building's layout. In addition, in some embodiments the described techniques may be used to provide an improved GUI in which a user may more accurately and quickly obtain and use building information that includes building dimensions (*e.g.,* for use in navigating an interior of one or more buildings), including in response to search requests, as part of providing personalized information to the user, as part of providing value estimates and/or other information about a building to a user (*e.g.,* after analysis of information about one or more target building floor plans that are similar to one or more initial floor plans or that otherwise match specified criteria), etc. Various other benefits are also provided by the described techniques, some of which are further described elsewhere herein.

As noted above, automated operations of a BOBSDM system may include determining information for a building floor plan in at least some embodiments. Such a floor plan of a building may include a 2D (two-dimensional) representation of various information about the building (*e.g.,* the rooms, doorways between rooms and other inter-room connections, exterior doorways, windows, etc.), and may be further associated with various types of supplemental or otherwise additional information (about the building (*e.g.,* data for a plurality of other building-related attributes) - such additional building information may, for example, include one or more of the following: a 3D, or three-dimensional, model of the building that includes height information (*e.g.,* for building walls and other vertical areas); a 2.5D, or two-and-a-half dimensional, model of the building that when rendered includes visual representations of walls and/or other vertical surfaces without explicitly modeling measured heights of those walls and/or other vertical surfaces; images and/or other types of data captured in rooms of the building, including panoramic images (*e.g.,* 360° panorama images); etc., as discussed in greater detail below.

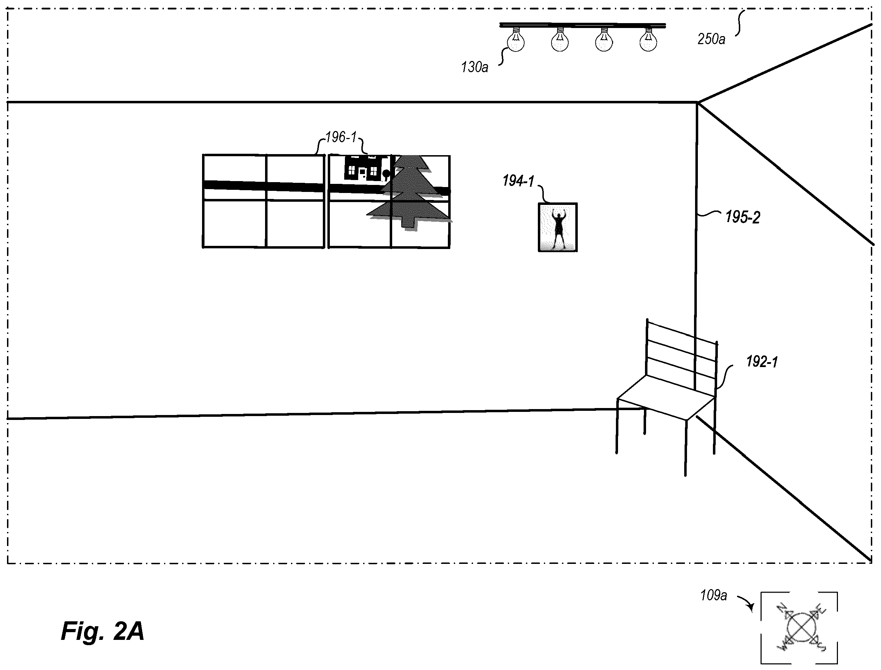

In addition, in at least some embodiments and situations, some or all of the images acquired for a building and associated with the building's floor plan may be panorama images that are each acquired at one of multiple acquisition locations in or around the building, such as to generate a panorama image at each such acquisition location from one or more of a video at that acquisition location (*e.g.,* a 360° video taken from a smartphone or other mobile device held by a user turning at that acquisition location), or multiple images acquired in multiple directions from the acquisition location (*e.g.,* from a smartphone or other mobile device held by a user turning at that acquisition location), or a simultaneous capture of all the image information (*e.g.,* using one or more fisheye lenses), etc. Such images may include visual data, and in at least some embodiments and situations, acquisition metadata regarding the acquisition of such panorama images may be obtained and used in various manners, such as data acquired from IMU (inertial measurement unit) sensors or other sensors of a mobile device as it is carried by a user or otherwise moved between acquisition locations (*e.g.,* compass heading data, GPS location data, etc.). It will be appreciated that such a panorama image may in some situations be represented in a spherical coordinate system and provide up to 360° coverage around horizontal and/or vertical axes, such that a user viewing a starting panorama image may move the viewing direction within the starting panorama image to different orientations to cause different images (or "views") to be rendered within the starting panorama image (including, if the panorama image is represented in a spherical coordinate system, to convert the image being rendered into a planar coordinate system). Additional details are included below related to acquisition and usage of panorama images or other images for a building, including with respect to Figures 2A-2C and associated descriptions.

In at least some embodiments, a BOBSDM system may operate in conjunction with one or more separate ICA (Image Capture and Analysis) systems and/or MIGM (Mapping Information and Generation Manager) systems, such as to obtain and use images from the ICA system and/or to obtain floor plan and other associated information for buildings from the MIGM system, while in other embodiments such an BOBSDM system may incorporate some or all functionality of such ICA and/or MIGM systems as part of the BOBSDM system. In yet other embodiments, the BOBSDM system may operate without using some or all functionality of the ICA and/or MIGM systems, such as if the BOBSDM system obtains information about images and/or building floor plans and associated information from other sources (*e.g.,* from manual capture of one or more such images by user(s), from manual creation or provision of such building floor plans and/or associated information by one or more users, etc.).

With respect to functionality of such an ICA system, it may perform automated operations in at least some embodiments to acquire images (*e.g.,* panorama images) at various acquisition locations associated with a building (*e.g.,* in the interior of multiple rooms of the building), and optionally further acquire metadata related to the image acquisition process (*e.g.,* compass heading data, GPS location data, etc.) and/or to movement of a capture device between acquisition locations - in at least some embodiments, such acquisition and subsequent use of acquired information may occur without having or using information from depth sensors or other distance-measuring devices about distances from images' acquisition locations to walls or other objects in a surrounding building or other structure. For example, in at least some such embodiments, such techniques may include using one or more mobile devices (*e.g*., a camera having one or more fisheye lenses and mounted on a rotatable tripod or otherwise having an automated rotation mechanism; a camera having one or more fisheye lenses sufficient to capture 360 degrees horizontally without rotation; a smart phone held in a constant position relative to a user (*e.g.,* chest height, eye height, etc.) and moved by the user, such as to rotate the user's body and held smart phone in a 360° circle around a vertical axis; a camera held by or mounted on a user or the user's clothing; a camera mounted on an aerial and/or ground-based drone or other robotic device; etc.) to capture visual data from a sequence of multiple acquisition locations within multiple rooms of a house (or other building). Additional details are included elsewhere herein regarding operations of device(s) implementing an ICA system, such as to perform such automated operations, and in some cases to further interact with ICA system operator user(s) to provide further functionality.

With respect to functionality of such an MIGM system, it may perform automated operations in at least some embodiments to analyze multiple 360° panorama images (and optionally other images) that have been acquired for a building interior (and optionally an exterior of the building), and determine room shapes and locations of passages connecting rooms for some or all of those panorama images, as well as to determine wall elements and other elements of some or all rooms of the building in at least some embodiments and situations. The types of connecting passages between two or more rooms may include one or more of doorway openings and other inter-room non-doorway wall openings, windows, stairways, non-room hallways, etc., and the automated analysis of the images may identify such elements based at least in part on identifying the outlines of the passages, identifying different content within the passages than outside them (*e.g.,* different colors or shading), etc. The automated operations may further include using the determined information to generate a floor plan for the building and to optionally generate other mapping information for the building, such as by using the inter-room passage information and other information to determine relative positions of the associated room shapes to each other, and to optionally add distance scaling information and/or various other types of information to the generated floor plan. In addition, the MIGM system may in at least some embodiments perform further automated operations to determine and associate additional information with a building floor plan and/or specific rooms or locations within the floor plan, such as to analyze images and/or other environmental information (*e.g.,* audio) captured within the building interior to determine particular attributes (*e.g.,* a color and/or material type and/or other characteristics of particular features or other elements, such as a floor, wall, ceiling, countertop, furniture, fixture, appliance, cabinet, island, fireplace, etc.; the presence and/or absence of particular features or other elements; etc.), or to otherwise determine relevant attributes (*e.g.,* directions that building features or other elements face, such as windows; views from particular windows or other locations; etc.). Additional details are included below regarding operations of computing device(s) implementing an MIGM system, such as to perform such automated operations and in some cases to further interact with one or more MIGM system operator user(s) in one or more manners to provide further functionality.

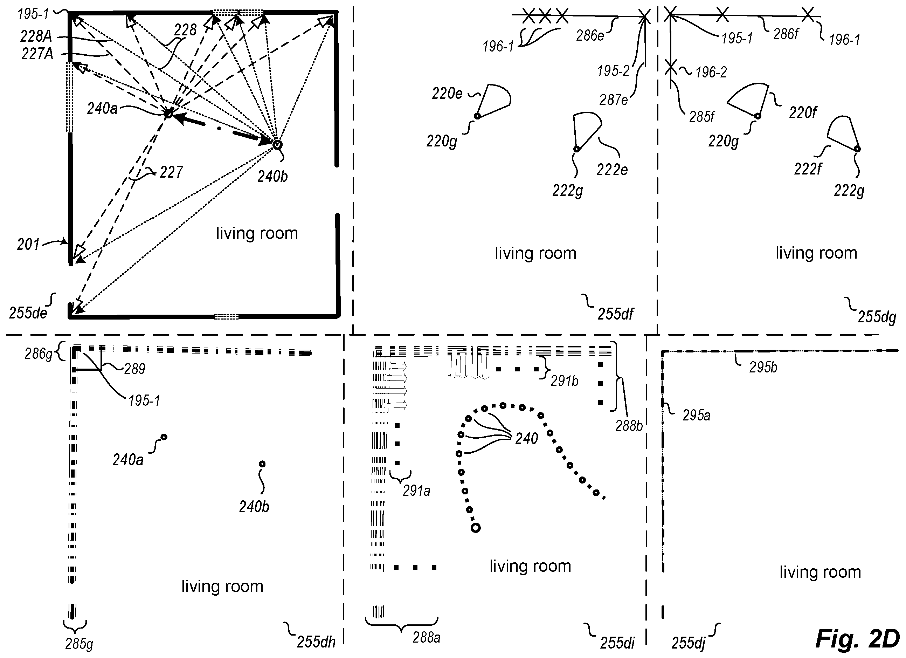

In some embodiments and situations, an adjacency graph may also be generated that represents information about room adjacencies for a building and that further stores or otherwise includes some or all such data for the building, such as from analysis of a floor plan and with at least some such data stored in or otherwise associated with nodes of the adjacency graph that represent some or all rooms of the floor plan *(*e*.g.,* with each node containing information about attributes of the room represented by the node), and/or with at least some such attribute data stored in or otherwise associated with edges between nodes that represent connections between adjacent rooms via doorways or other non-doorway inter-room wall openings, or in some situations further represent adjacent rooms that share at least a portion of at least one wall and optionally a full wall without any direct inter-room opening connecting those two rooms (*e.g.,* with each edge containing information about connectivity status between the rooms represented by the nodes that the edge inter-connects, such as whether an inter-room opening exists between the two rooms, and/or a type of inter-room opening or other type of adjacency between the two rooms such as without any direct inter-room wall opening connection). In some embodiments and situations, the floor plan and/or adjacency graph may further represent at least some information external to the building, such as exterior areas adjacent to doorways or other wall openings between the building and the exterior and/or other accessory structures on the same property as the building (*e.g.,* a garage, shed, pool house, separate guest quarters, mother-in-law unit or other accessory dwelling unit, pool, patio, deck, sidewalk, garden, yard, etc.), or more generally some or all external areas of a property that includes one or more buildings (*e.g.,* a house and one or more outbuildings or other accessory structures) - such exterior areas and/or other structures may be represented in various manners in the adjacency graph and/or on the floor plan, such as via separate nodes for each such exterior area or other structure in the adjacency graph or by placing the floor plan on a representation of the property that includes the external areas, or instead as attribute information associated with corresponding nodes or edges of the adjacency graph or instead with the adjacency graph as a whole (for the building as a whole). The adjacency graph may further have associated attribute information for the corresponding rooms and inter-room connections in at least some embodiments, such as to represent within the adjacency graph some or all of the information available on a floor plan and otherwise associated with the floor plan (or in some embodiments and situations, information in and associated with a 3D model of the building) - for example, if there are images associated with particular rooms of the floor plan or other associated areas (*e.g.,* external areas), corresponding visual attributes may be included within the adjacency graph, whether as part of the associated rooms or other areas, or instead as a separate layer of nodes within the graph that represent the images. In embodiments with adjacency information in a form other than an adjacency graph, some or all of the above-indicated types of information may be stored in or otherwise associated with the adjacency information, including information about rooms, about adjacencies between rooms, about connectivity status between adjacent rooms, about attributes of the building, etc. Additional details are included below regarding the generation and use of floor plans and/or adjacency graphs, including with respect to the examples of Figures 2D-2H and their associated descriptions.

In addition, automated operations of a BOBSDM system may further include generating and using one or more vector-based embeddings (also referred to herein as a "vector embedding") to concisely represent information in an adjacency graph for a floor plan of a building, such as to summarize the semantic meaning and spatial relationships of the floor plan in a manner that enables reconstruction of some or all of the floor plan from the vector embedding. Such a vector embedding may be generated in various manners in various embodiments, such as via the use of representation learning and one or more trained machine learning models, and in at least some such embodiments may be encoded in a format that is not easily discernible to a human reader. Non-exclusive examples of techniques for generating such vector embeddings are included in the following documents, "Symmetric Graph Convolution Autoencoder For Unsupervised Graph Representation Learning" by Jiwoong Park et al., 2019 International Conference On Computer Vision, August 7, 2019; "Inductive Representation Learning On Large Graphs" by William L Hamilton et al., 31st Conference On Neural Information Processing Systems 2017, June 7, 2017; and "Variational Graph Auto-Encoders" by Thomas N. Kipf et al., 30th Conference On Neural Information Processing Systems 2017 (Bayesian Deep Learning Workshop), November 21, 2016.

As noted above, a floor plan may have various information that is associated with individual rooms and/or with inter-room connections and/or with a corresponding building and/or encompassing property as a whole, and the corresponding adjacency graph and/or vector embedding(s) for such a floor plan may include some or all such associated information (*e.g.,* represented as attributes of nodes for rooms in an adjacency graph and/or attributes of edges for inter-room connections in an adjacency graph and/or represented as attributes of the adjacency graph as a whole, such as in a node representing the overall building, and with corresponding information encoded in the associated vector embedding(s)). Such associated information may include a variety of types of data, including information about one or more of the following non-exclusive examples: room types, room dimensions, locations of windows and doors and other inter-room openings in a room, room shape, a view type for each exterior window, information about and/or copies of images taken in a room, information about and/or copies of audio or other data captured in a room, information of various types about features of one or more rooms (*e.g.,* as automatically identified from analysis of images, as supplied by operator users of the BOBSDM system and/or by end-users viewing information about the floor plan and/or by operator users of ICA and/or MIGM systems as part of capturing information about a building and generating a floor plan for the building, etc.), attributes of structures and objects (*e.g.,* colors, shapes, materials, age, condition, quality, etc.), types of inter-room connections, dimensions of inter-room connections, etc. Furthermore, in at least some embodiments, one or more additional subjective attributes may be determined for and associated with the floor plan, such as via analysis of the floor plan information (*e.g.,* an adjacency graph for the floor plan) by one or more trained machine learning models (*e.g.,* classification neural network models) to identify floor plan characteristics for a building as a whole or a particular building floor (*e.g.,* an open floor plan; a typical/normal versus atypical/odd/unusual floor plan; a standard versus nonstandard floor plan; a floor plan that is accessibility friendly, such as by being accessible with respect to one or more characteristics such as disability and/or advanced age; etc.) - in at least some such embodiments, the one or more classification neural network models are part of the BOBSDM system and are trained via supervised learning using labeled data that identifies floor plans having each of the possible characteristics, while in other embodiments such classification neural network models may instead use unsupervised clustering. Additional details are included below regarding the determination and use of attribute information for floor plans, including with respect to the examples of Figures 2D-2H and their associated description.

After an adjacency graph and one or more vector embeddings are generated for a floor plan and associated information of a building, that generated information may be used by the BOBSDM system as specified criteria to automatically determine one or more other similar or otherwise matching floor plans of other buildings in various manners in various embodiments. For example, in some embodiments, an initial floor plan is identified, and one or more corresponding vector embeddings for the initial floor plan are generated and compared to generated vector embeddings for other candidate floor plans in order to determine a difference between the initial floor plan's vector embedding(s) and the vector embeddings of some or all of the candidate floor plans, with smaller differences between two vector embeddings corresponding to higher degrees of similarity between the building information represented by those vector embeddings. Differences between two such vector embeddings may be determined in various manners in various embodiments, including, as non-exclusive examples, by using one or more of the following distance metrics: Euclidean distance, cosine distance, graph edit distance, a custom distance measure specified by a user, etc.; and/or otherwise determining similarity without use of such a distance metrics. In at least some embodiments, multiple such initial floor plans may be identified and used in the described manner to determine a combined distance between a group of vector embeddings for the multiple initial floor plans and the vector embeddings for each of multiple other candidate floor plans, such as by determining individual distances for each of the initial floor plans to a given other candidate floor plan and by combining the multiple individual determined distances in one or more manners (*e.g.,* a mean or other average, a cumulative total, etc.) to generate the combined distance for the group of vector embeddings of the multiple initial floor plans to that given other candidate floor plan.

Furthermore, in some embodiments, one or more explicitly specified criteria other than one or more initial floor plans are received (whether in addition to or instead of receiving one or more initial floor plans), and the corresponding vector embedding(s) for each of multiple candidate floor plans are compared to information generated from the specified criteria in order to determine which of the candidate floor plans satisfy the specified criteria (*e.g.,* are a match above a defined similarity threshold), such as by generating a representation of a building that corresponds to the criteria (*e.g.,* has attributes identified in the criteria) and generating one or more vector embeddings for the building representation for use in vector embedding comparisons in the manners discussed above. The specified criteria may be of various types in various embodiments and situations, such as one or more of the following non-exclusive examples: search terms corresponding to specific attributes of rooms and/or inter-room connections and/or buildings as a whole (whether objective attributes that can be independently verified and/or replicated, and/or subjective attributes that are determined via use of corresponding classification neural networks); information identifying adjacency information between two or more rooms or other areas; information about views available from windows or other exterior openings of the building; information about directions of windows or other structural features or other elements of the building (*e.g.,* such as to determine natural lighting information available via those windows or other structural elements, optionally at specified days and/or seasons and/or times); etc. Non-exclusive illustrative examples of such specified criteria include the following: a bathroom adjacent to bedroom (*e.g.,* without an intervening hall or other room); a deck adjacent to a family room (optionally with a specified type of connection, such as French doors); 2 bedrooms facing south; a kitchen with a tile-covered island and a northward-facing view; a master bedroom with a view of the ocean or more generally of water; any combination of such specified criteria; etc. In addition, in some embodiments, one or more target floor plans are identified that are similar to specified criteria associated with a particular end-user (*e.g.,* based on one or more initial target floor plans that are selected by the end-user and/or are identified as previously being of interest to the end-user, whether based on explicit and/or implicit activities of the end-user to specify such floor plans; based on one or more search criteria specified by the end-user, whether explicitly and/or implicitly; etc.), and are used in further automated activities to personalize interactions with the end-user. Such further automated personalized interactions may be of various types in various embodiments, and in some embodiments may include displaying or otherwise presenting information to the end-user about the target floor plan(s) and/or additional associated information.

The described techniques may further include additional operations in some embodiments. For example, in at least some embodiments, machine learning techniques may be used to learn the attributes and/or other characteristics of adjacency graphs to encode in corresponding vector embeddings that are generated, such as the attributes and/or other characteristics that best enable subsequent automated identification of building floor plans having attributes satisfying target criteria (*e.g.,* number of bedrooms; number of bathrooms; connectivity between rooms; size and/or dimensions of each room; number of windows/doors in each room; types of views available from exterior windows, such as water, mountain, a back yard or other exterior area of the property, etc.; location of windows/doors in each room; etc.). In addition, in at least some embodiments, machine learning techniques may be used to identify objects of one or more types in one or more images (*e.g.,* doorways, kitchen cabinets, etc.), such as by one or more machine learning models trained to determine such information (*e.g.,* a machine learning model specific to each defined object type). Furthermore, in at least some embodiments, machine learning techniques may be used to determine an estimated camera height for one or more images, such as by one or more machine learning models trained to determine such information (*e.g.,* a machine learning model specific to each defined object type).

For illustrative purposes, some embodiments are described below in which specific types of information are acquired, used and/or presented in specific ways for specific types of structures and by using specific types of devices - however, it will be understood that the described techniques may be used in other manners in other embodiments, and that the invention is thus not limited to the exemplary details provided. As one non-exclusive example, while specific types of data structures (*e.g.,* floor plans, adjacency graphs, vector embeddings, etc.) are generated and used in specific manners in some embodiments, it will be appreciated that other types of information to describe floor plans and other associated information may be similarly generated and used in other embodiments, including for buildings (or other structures or layouts) separate from houses, and that floor plans identified as matching specified criteria may be used in other manners in other embodiments. In addition, the term "building" refers herein to any partially or fully enclosed structure, typically but not necessarily encompassing one or more rooms that visually or otherwise divide the interior space of the structure - non-limiting examples of such buildings include houses, apartment buildings or individual apartments therein, condominiums, office buildings, commercial buildings or other wholesale and retail structures (*e.g.,* shopping malls, department stores, warehouses, etc.), supplemental structures on a property with another main building (*e.g.,* a detached garage or shed on a property with a house), etc. The term "acquire" or "capture" as used herein with reference to a building interior, acquisition location, or other location (unless context clearly indicates otherwise) may refer to any recording, storage, or logging of media, sensor data, and/or other information related to spatial characteristics and/or visual characteristics and/or otherwise perceivable characteristics of the building interior or subsets thereof, such as by a recording device or by another device that receives information from the recording device. As used herein, the term "panorama image" may refer to a visual representation that is based on, includes or is separable into multiple discrete component images originating from a substantially similar physical location in different directions and that depicts a larger field of view than any of the discrete component images depict individually, including images with a sufficiently wide-angle view from a physical location to include angles beyond that perceivable from a person's gaze in a single direction. The term "sequence" of acquisition locations, as used herein, refers generally to two or more acquisition locations that are each visited at least once in a corresponding order, whether or not other non-acquisition locations are visited between them, and whether or not the visits to the acquisition locations occur during a single continuous period of time or at multiple different times, or by a single user and/or device or by multiple different users and/or devices. In addition, various details are provided in the drawings and text for exemplary purposes, but are not intended to limit the invention's scope. For example, sizes and relative positions of drawing elements are not necessarily drawn to scale, with some details omitted or provided with greater prominence (*e.g.,* via size and positioning) to enhance legibility clarity. Furthermore, identical reference numbers may be used in the drawings to identify same or similar elements or acts.

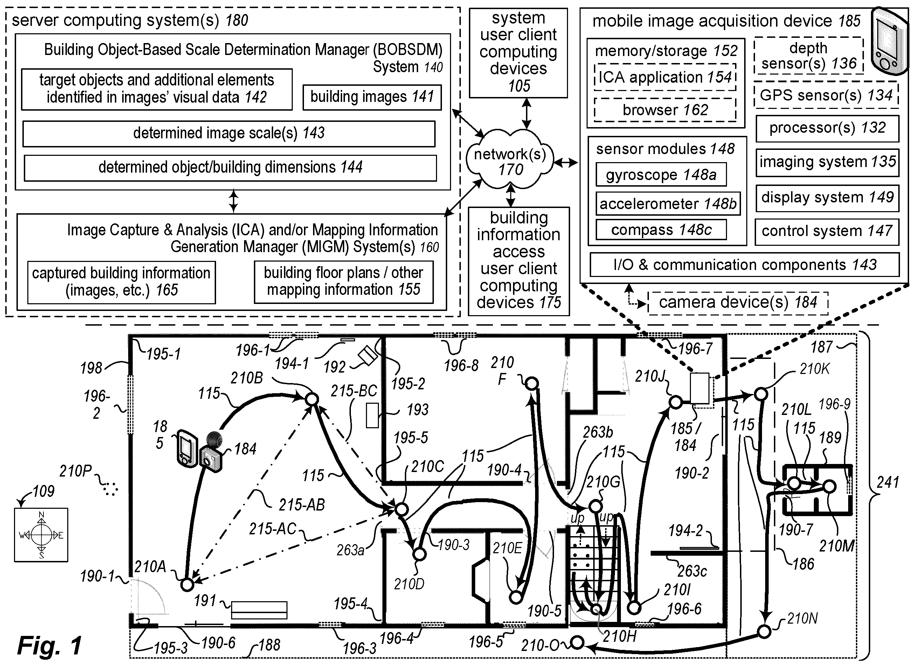

Figure 1 includes an example block diagram of various computing devices and systems that may participate in the described techniques in some embodiments, such as with respect to an example building 198 (in this example, a house), and by the example Building Object-Based Scale Determination Manager ("BOBSDM") system 140 executing on one or more server computing systems 180 in this example embodiment.

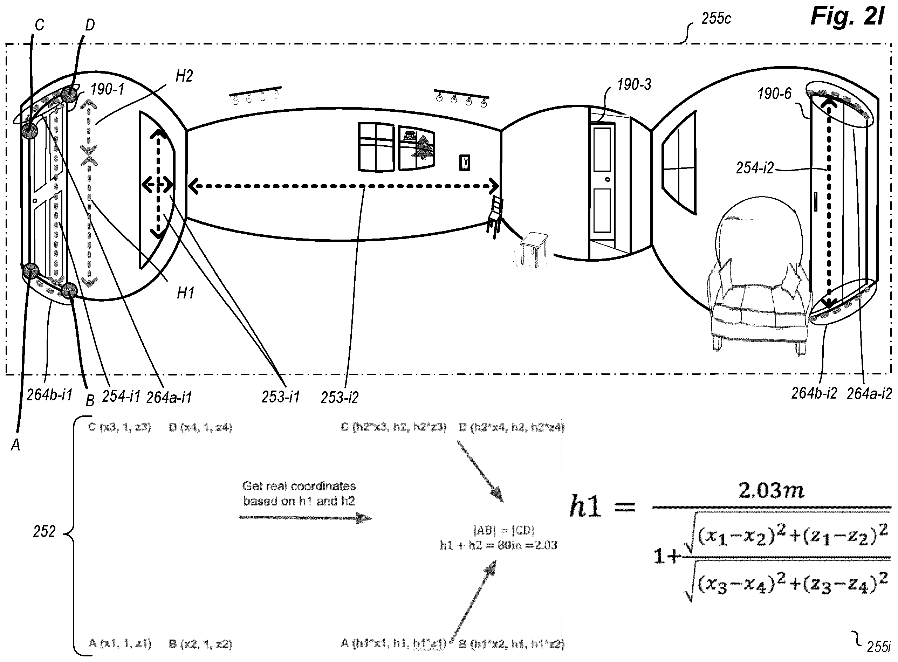

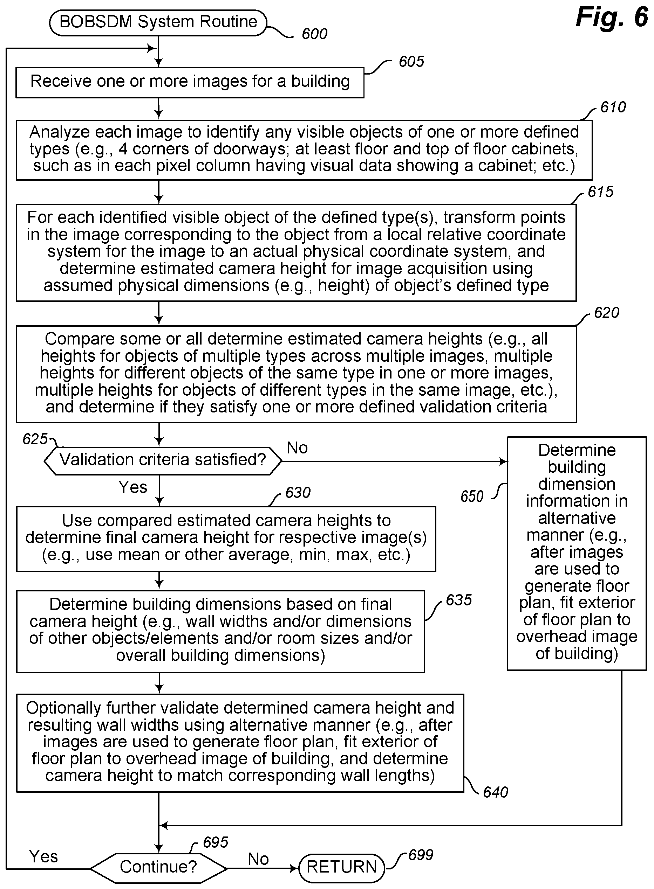

In the illustrated embodiment, the BOBSDM system 140 analyzes obtained building images 141 (*e.g.,* some or all images 165 acquired by the ICA system 160) for a building in order to determine dimension information 143 for the building (*e.g.,* sizes of visible objects, rooms, etc.), such as by using visible objects 142 that are identified in the images of one or more defined types (*e.g.,* doorways, floor cabinets, etc.) and that have standardized or otherwise expected heights or other sizes, in order to estimate the camera height(s) of one or more camera devices during capturing of those images and optionally other image scale information 143. The BOBSDM system may further use the determined building dimension information in various manners, including to determine and associate sizes of rooms and/or the building as a whole with a floor plan of the building, such as for use in improved navigation of the building. In some embodiments and situations, the BOBSDM system may optionally further use supporting information supplied by system operator users via computing devices 105 over intervening computer network(s) 170, and in some embodiments and situations some or all of the determinations performed by the BOBSDM system may include using one or more trained machine learning models (*e.g.,* one or more trained neural networks). In some embodiments, the building images 141 that are analyzed by the BOBSDM system may be obtained in manners other than via ICA and/or MIGM systems 160 (*e.g.,* if such ICA and/or MIGM systems are not part of the BOBSDM system), such as to receive building images from other sources. Additional details related to the automated operations of the BOBSDM system are included elsewhere herein, including with respect to Figures 2I-2L and Figure 6.

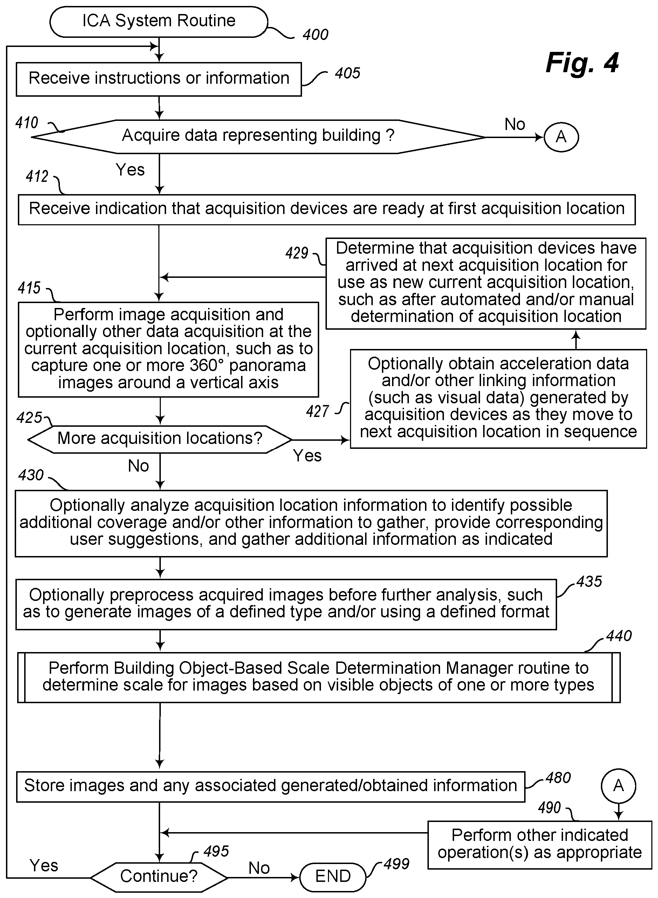

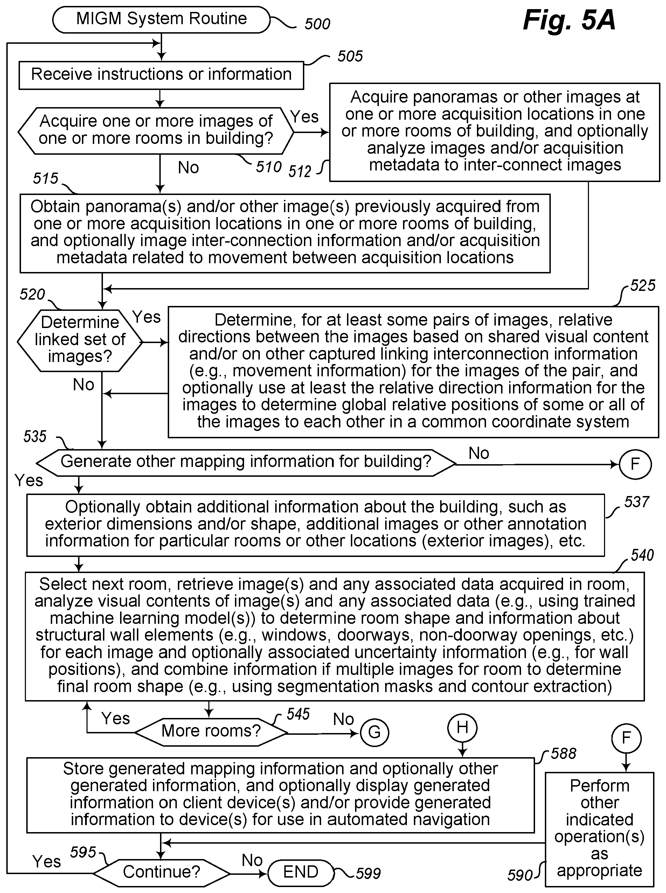

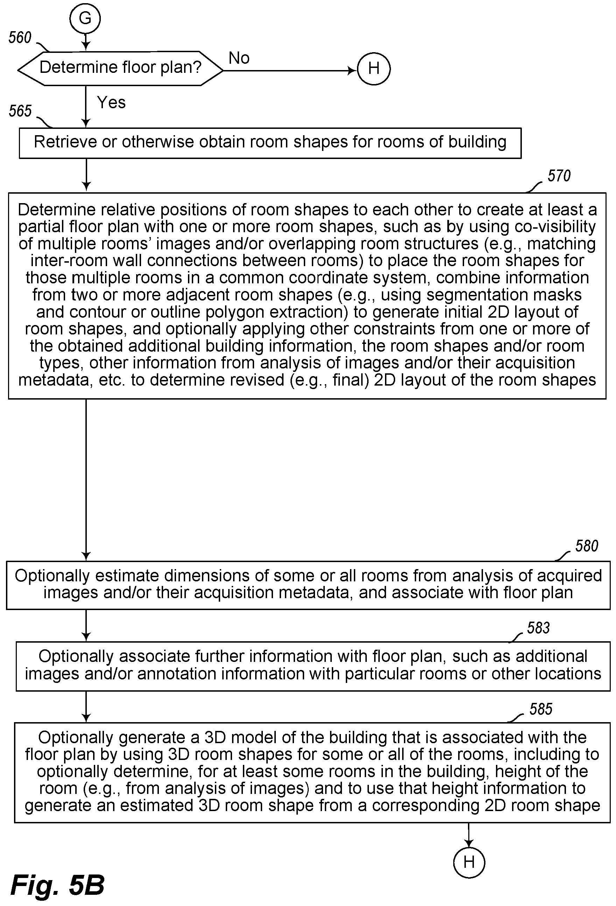

In addition, an Interior Capture and Analysis ("ICA") system (*e.g.,* an ICA system 160 executing on the one or more server computing systems 180, such as part of the BOBSDM system; an optional ICA system application 154 executing on a mobile image acquisition device 185; etc.) captures information 165 with respect to one or more buildings or other structures (*e.g.,* by capturing one or more 360° panorama images and/or other images for multiple acquisition locations 210 in an example house 198), and a MIGM (Mapping Information Generation Manager) system 160 executing on the one or more server computing systems 180 (e.g., as part of the BOBSDM system) further uses that captured building information and optionally additional supporting information (*e.g.,* supplied by system operator users via computing devices 105 over intervening computer network(s) 170) to generate and provide building floor plans 155 and/or other mapping-related information (not shown) for the building(s) or other structure(s). In the illustrated embodiment, the ICA and MIGM systems 160 are operating as part of the BOBSDM system 140 that analyzes building images 141 (*e.g.,* images 165 acquired by the ICA system) and generates and uses corresponding building information 144 (*e.g.,* as part of floor plan generation by the MIGM system) in one or more further automated manners, but in other embodiments may operate separately from the BOBSDM system. Similarly, while the ICA and MIGM systems 160 are illustrated in this example embodiment as executing on the same server computing system(s) 180 as the BOBSDM system (*e.g.,* with all systems being operated by a single entity or otherwise being executed in coordination with each other, such as with some or all functionality of all the systems integrated together), in other embodiments the ICA system 160 and/or MIGM system 160 and/or BOBSDM system 140 may operate on one or more other systems separate from the system(s) 180 (*e.g.,* on mobile device 185; one or more other computing systems, not shown; etc.), whether instead of or in addition to the copies of those systems executing on the system(s) 180 (*e.g.,* to have a copy of the MIGM system 160 executing on the device 185 to incrementally generate at least partial building floor plans as building images are acquired by the ICA system 160 executing on the device 185 and/or by that copy of the MIGM system, while another copy of the MIGM system optionally executes on one or more server computing systems to generate a final complete building floor plan after all images are acquired), and in yet other embodiments the BOBSDM may instead operate without an ICA system and/or MIGM system and instead obtain panorama images (or other images) and/or building floor plans from one or more external sources. Additional details related to the automated operation of the ICA and MIGM systems are included elsewhere herein, including with respect to Figures 2A-2H and with respect to Figures 4 and 5A-5B, respectively.

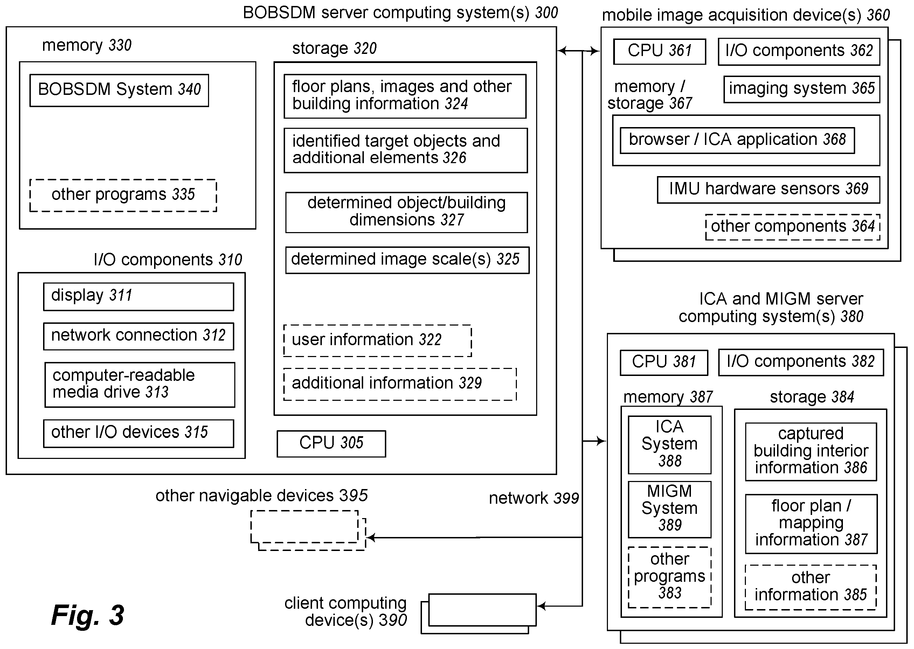

Various components of the mobile computing device 185 are also illustrated in Figure 1, including one or more hardware processors 132 (*e.g.,* CPUs, GPUs, etc.) that execute software (*e.g.,* optional ICA application 154, optional browser 162, etc.) using executable instructions stored and/or loaded on one or more memory/storage components 152 of the device 185, and optionally one or more imaging systems 135 of one or more types to acquire visual data of one or more panorama images 165 and/or other images (not shown, such as rectilinear perspective images) - some or all such images may in some embodiments be supplied by one or more separate associated camera devices 184 (*e.g.,* via a wired/cabled connection, via Bluetooth or other inter-device wireless communications, etc.), whether in addition to or instead of images captured by the mobile device 185. The illustrated embodiment of mobile device 185 further includes one or more sensor modules 148 that include a gyroscope 148a, accelerometer 148b and compass 148c in this example (*e.g.,* as part of one or more IMU units, not shown separately, on the mobile device), one or more control systems 147 managing I/O (input/output) and/or communications and/or networking for the device 185 (*e.g.,* to receive instructions from and present information to the user) such as for other device I/O and communication components 143 (*e.g.,* network interfaces or other connections, keyboards, mice or other pointing devices, microphones, speakers, GPS receivers, etc.), a display system 149 (*e.g.,* with a touch-sensitive screen), optionally one or more depth-sensing sensors or other distance-measuring components 136 of one or more types, optionally a GPS (or Global Positioning System) sensor 134 or other position determination sensor (not shown in this example), etc. Other computing devices/systems 105, 175 and 180 and/or camera devices 184 may include various hardware components and stored information in a manner analogous to mobile device 185, which are not shown in this example for the sake of brevity, and as discussed in greater detail below with respect to Figure 3.

One or more users (not shown) of one or more client computing devices 175 may further interact over one or more computer networks 170 with the BOBSDM system 140 (and optionally the ICA system 160 and/or MIGM system 160), such as to obtain determined building dimension information and/or to assist in the determining of the building dimension information, as well as obtaining and using the underlying images and/or resulting floor plans in one or more further automated manners - such interactions by the user(s) may include, for example, specifying target criteria to use in searching for corresponding floor plans or otherwise providing information about target criteria of interest to the users, or obtaining and optionally interacting with one or more particular identified floor plans and/or with additional associated information (*e.g.,* to change between a floor plan view and a view of a particular image at an acquisition location within or near the floor plan; to change the horizontal and/or vertical viewing direction from which a corresponding view of a panorama image is displayed, such as to determine a portion of a panorama image to which a current user viewing direction is directed, etc.). In addition, a floor plan (or portion of it) may be linked to or otherwise associated with one or more other types of information, including for a floor plan of a multi-story or otherwise multi-level building to have multiple associated sub-floor plans for different stories or levels that are interlinked (*e.g.,* via connecting stairway passages), for a two-dimensional ("2D") floor plan of a building to be linked to or otherwise associated with a three-dimensional ("3D") rendering of the building, etc. Also, while not illustrated in Figure 1, in some embodiments the client computing devices 175 (or other devices, not shown) may receive and use information about determined building dimensions and/or about identified floor plans or other mapping-related information in additional manners, such as to control or assist automated navigation activities by those devices (*e.g.,* by autonomous vehicles or other devices), whether instead of or in addition to display of the identified information.

In the depicted computing environment of Figure 1, the network 170 may be one or more publicly accessible linked networks, possibly operated by various distinct parties, such as the Internet. In other implementations, the network 170 may have other forms. For example, the network 170 may instead be a private network, such as a corporate or university network that is wholly or partially inaccessible to non-privileged users. In still other implementations, the network 170 may include both private and public networks, with one or more of the private networks having access to and/or from one or more of the public networks. Furthermore, the network 170 may include various types of wired and/or wireless networks in various situations. In addition, the client computing devices 175 and server computing systems 180 may include various hardware components and stored information, as discussed in greater detail below with respect to Figure 3.

In the example of Figure 1, the ICA system may perform automated operations involved in generating multiple 360° panorama images at multiple associated acquisition locations (*e.g.,* in multiple rooms or other locations within a building or other structure and optionally around some or all of the exterior of the building or other structure), such as using visual data acquired via the mobile device(s) 185 and/or associated camera devices 184, and for use in generating and providing a representation of an interior of the building or other structure. For example, in at least some such embodiments, such techniques may include using one or more mobile devices (*e.g.,* a camera having one or more fisheye lenses and mounted on a rotatable tripod or otherwise having an automated rotation mechanism, a camera having sufficient fisheye lenses to capture 360° horizontally without rotation, a smart phone held and moved by a user, a camera held by or mounted on a user or the user's clothing, etc.) to capture data from a sequence of multiple acquisition locations within multiple rooms of a house (or other building), and to optionally further capture data involved in movement of the acquisition device (*e.g.,* movement at an acquisition location, such as rotation; movement between some or all of the acquisition locations, such as for use in linking the multiple acquisition locations together; etc.), in at least some cases without having distances between the acquisition locations being measured or having other measured depth information to objects in an environment around the acquisition locations (*e.g.,* without using any depth-sensing sensors). After an acquisition location's information is captured, the techniques may include producing a 360° panorama image from that acquisition location with 360 degrees of horizontal information around a vertical axis (*e.g.,* a 360° panorama image that shows the surrounding room in an equirectangular format), and then providing the panorama images for subsequent use by the MIGM and/or BOBSDM systems.

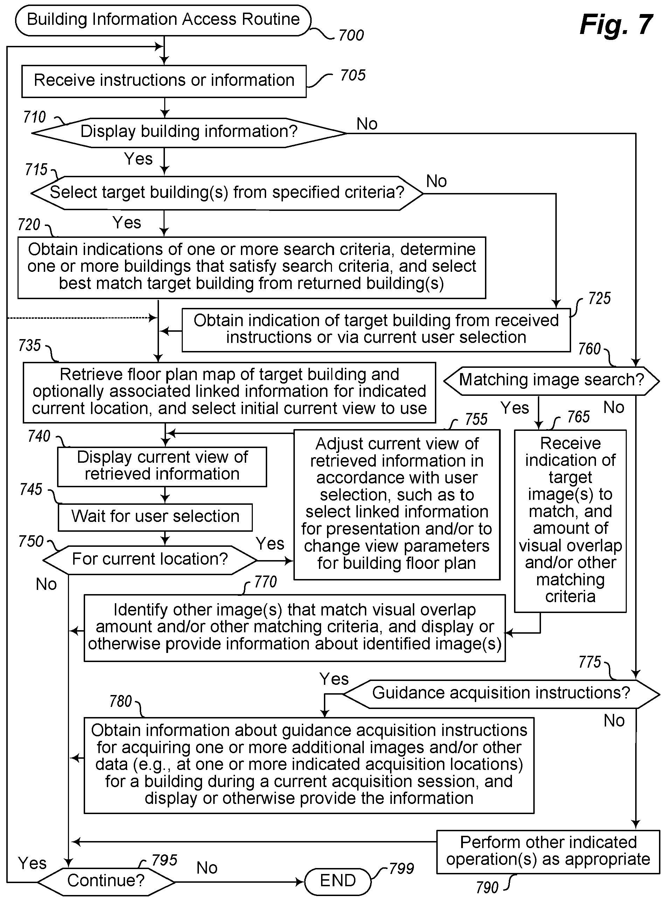

One or more end users (not shown) of one or more building information access client computing devices 175 may further interact over computer networks 170 with the BOBSDM system 140 (and optionally the MIGM system 160 and/or ICA system 160), such as to obtain, display and interact with a generated floor plan (and/or other generated mapping information) and/or associated images (*e.g.,* by supplying information about one or more indicated buildings of interest and/or other criteria and receiving information about one or more corresponding matching buildings), as discussed in greater detail elsewhere herein, including with respect to Figure 7. In addition, while not illustrated in Figure 1, a floor plan (or portion of it) may be linked to or otherwise associated with one or more additional types of information, such as one or more associated and linked images or other associated and linked information, including for a two-dimensional ("2D") floor plan of a building to be linked to or otherwise associated with a separate 2.5D model floor plan rendering of the building and/or a 3D model floor plan rendering of the building, etc., and including for a floor plan of a multi-story or otherwise multi-level building to have multiple associated sub-floor plans for different stories or levels that are interlinked (*e.g.,* via connecting stairway passages) or are part of a common 2.5D and/or 3D model. Accordingly, non-exclusive examples of an end user's interactions with a displayed or otherwise generated 2D floor plan of a building may include one or more of the following: to change between a floor plan view and a view of a particular image at an acquisition location within or near the floor plan; to change between a 2D floor plan view and a 2.5D or 3D model view that optionally includes images texture-mapped to walls of the displayed model; to change the horizontal and/or vertical viewing direction from which a corresponding subset view of (or portal into) a panorama image is displayed, such as to determine a portion of a panorama image in a 3D coordinate system to which a current user viewing direction is directed, and to render a corresponding planar image that illustrates that portion of the panorama image without the curvature or other distortions present in the original panorama image; etc. In addition, while not illustrated in Figure 1, in some embodiments the client computing devices 175 (or other devices, not shown) may receive and use generated floor plans and/or other generated mapping-related information in additional manners, such as to control or assist automated navigation activities by those devices (*e.g.,* by autonomous vehicles or other devices), whether instead of or in addition to display of the generated information.

Figure 1 further depicts an exemplary building interior environment in which 360° panorama images and/or other images are acquired, such as by the ICA system and for use by the BOBSDM and/or MIGM systems to determine building dimension information and to generate and provide one or more corresponding building floor plans (*e.g.,* multiple incremental partial building floor plans), respectively. In particular, Figure 1 illustrates one story of a multi-story house (or other building) 198 with an interior that was captured at least in part via multiple panorama images, such as by a mobile image acquisition device 185 with image acquisition capabilities and/or one or more associated camera devices 184 as they are moved through the building interior to a sequence of multiple acquisition locations 210 (*e.g.,* starting at acquisition location 210A, moving to acquisition location 210B along travel path 115, etc., and ending at acquisition location 210-O or 210P outside of the building). An embodiment of the ICA system may automatically perform or assist in the capturing of the data representing the building interior (as well as to further analyze the captured data to generate 360° panorama images to provide a visual representation of the building interior), and an embodiment of the MIGM system may analyze the visual data of the acquired images to generate one or more building floor plans for the house 198 (*e.g.,* multiple incremental building floor plans, including to determine directions between images, such as directions 215-AB, 215-AC and 215-BC between image acquisition locations 210A, 210B and 210C). While such a mobile image acquisition device may include various hardware components, such as a camera, one or more sensors (*e.g.,* a gyroscope, an accelerometer, a compass, etc., such as part of one or more IMUs, or inertial measurement units, of the mobile device; an altimeter; light detector; etc.), a GPS receiver, one or more hardware processors, memory, a display, a microphone, etc., the mobile device may not in at least some embodiments have access to or use equipment to measure the depth of objects in the building relative to a location of the mobile device, such that relationships between different panorama images and their acquisition locations in such embodiments may be determined in part or in whole based on features in different images but without using any data from any such depth sensors, while in other embodiments such depth data may be obtained and used. In addition, while directional indicator 109 is provided in Figure 1 for reference of the reader relative the example house 198, the mobile device and/or ICA system may not use such absolute directional information and/or absolute locations in at least some embodiments, such as to instead determine relative directions and distances between acquisition locations 210 without regard to actual geographical positions or directions in such embodiments, while in other embodiments such absolute directional information and/or absolute locations may be obtained and used.

In operation, the mobile device 185 and/or camera device(s) 184 arrive at a first acquisition location 210A within a first room of the building interior (in this example, in a living room accessible via an external door 190-1), and captures or acquires a view of a portion of the building interior that is visible from that acquisition location 210A (*e.g.,* some or all of the first room, and optionally small portions of one or more other adjacent or nearby rooms, such as through doorway wall openings, non-doorway wall openings, hallways, stairways or other connecting passages from the first room). The view capture may be performed in various manners as discussed herein, and may include a number of objects or other features (*e.g.,* structural details) that may be visible in images captured from the acquisition location - in the example of Figure 1, such objects or other features within the building 198 include the doorways 190 (including 190-1 through 190-6, such as with swinging and/or sliding doors), windows 196 (including 196-1 through 196-8), corners or edges 195 (including corner 195-1 in the northwest corner of the building 198, corner 195-2 in the northeast corner of the first room, corner 195-3 in the southwest corner of the first room, corner 195-4 in the southeast corner of the first room, corner 195-5 at the northern edge of the inter-room passage between the first room and a hallway, etc.), furniture 191-193 (*e.g.,* a couch 191; chair 192; table 193; etc.), pictures or paintings or televisions or other hanging objects 194 (such as 194-1 and 194-2) hung on walls, light fixtures (not shown in Figure 1), various built-in appliances or fixtures or other structural elements (not shown in Figure 1), etc. The user may also optionally provide a textual or auditory identifier to be associated with an acquisition location and/or a surrounding room, such as "living room" for one of acquisition locations 210A or 210B or for the room including acquisition locations 210A and/or 210B, while in other embodiments the ICA and/or MIGM system may automatically generate such identifiers (*e.g.,* by automatically analyzing images and/or video and/or other recorded information for a building to perform a corresponding automated determination, such as by using machine learning; based at least in part on input from ICA and/or MIGM system operator users; etc.) or the identifiers may not be used.

After the first acquisition location 210A has been captured, the mobile device 185 and/or camera device(s) 184 may move or be moved to a next acquisition location (such as acquisition location 210B), optionally recording images and/or video and/or other data from the hardware components (*e.g.,* from one or more IMUs, from the camera, etc.) during movement between the acquisition locations. At the next acquisition location, the mobile 185 and/or camera device(s) 184 may similarly capture a 360° panorama image and/or other type of image from that acquisition location. This process may repeat for some or all rooms of the building and in some cases external to the building, as illustrated for additional acquisition locations 210C-210P in this example, with the images from acquisition locations 210A to 210-O being captured in a single image acquisition session in this example (*e.g.,* in a substantially continuous manner, such as within a total of 5 minutes or 15 minutes), and with the image from acquisition location 210P optionally being acquired at a different time (*e.g.,* from a street adjacent to the building or front yard of the building). In this example, multiple of the acquisition locations 210K-210P are external to but associated with the building 198, including acquisition locations 210L and 210M in one or more additional structures 189 on the same property 241 (*e.g.,* an ADU, or accessory dwelling unit; a garage; a shed; etc.), acquisition location 210K on an external deck or patio 186, and acquisition locations 210N-210P at multiple yard locations on the property (*e.g.,* backyard 187, side yard 188, front yard including acquisition location 210P, etc.). The acquired images for each acquisition location may be further analyzed, including in some embodiments to render or otherwise place each panorama image in an equirectangular format, whether at the time of image acquisition or later, as well as further analyzed by the MIGM and/or BOBSDM systems in the manners described herein.

Various details are provided with respect to Figure 1, but it will be appreciated that the provided details are non-exclusive examples included for illustrative purposes, and other embodiments may be performed in other manners without some or all such details.

Figures 2A-2L illustrate examples of automatically analyzing visual data of images acquired at a building to determine building information that includes building dimensions and for subsequently using such information in one or more automated manners, such as for the building 198 discussed in Figure 1.

In particular, Figure 2A illustrates an example image 250a, such as a non-panorama perspective image taken in a northeasterly direction from acquisition location 210B in the living room of house 198 of Figure 1 (or a northeasterly facing subset view of a 360° panorama image taken from that acquisition location and formatted in a rectilinear manner) - the directional indicator 109a is further displayed in this example to illustrate the northeasterly direction in which the image is taken. In the illustrated example, the displayed image includes built-in elements (*e.g.,* light fixture 130a), furniture (*e.g.,* chair 192-1), two windows 196-1, and a picture 194-1 hanging on the north wall of the living room. No inter-room passages into or out of the living room (*e.g.,* doorways or other wall openings) are visible in this image. However, multiple room borders are visible in the image 250a, including horizontal borders between a visible portion of the north wall of the living room and the living room's ceiling and floor, horizontal borders between a visible portion of the east wall of the living room and the living room's ceiling and floor, and the inter-wall vertical border 195-2 between the north and east walls.

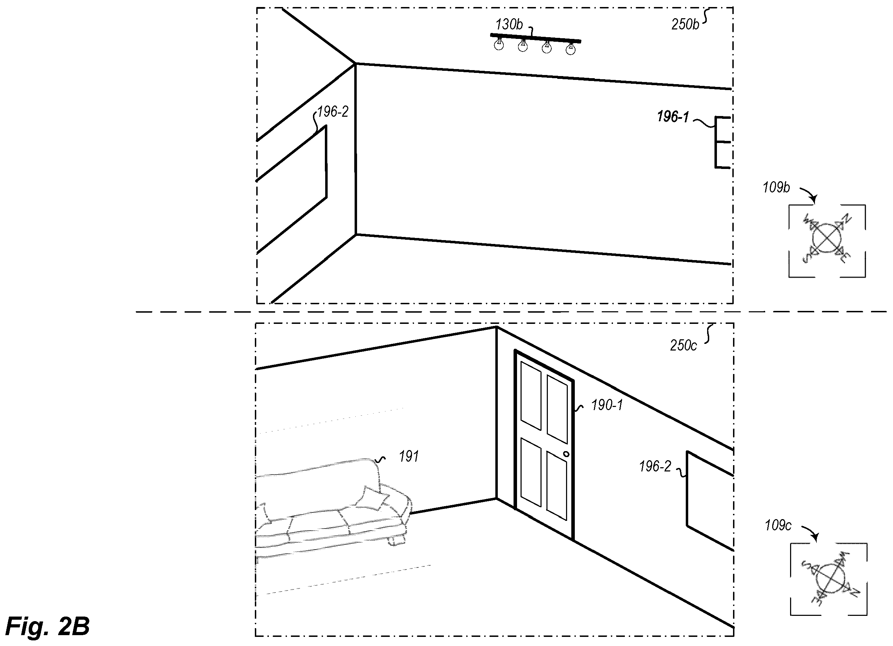

Figure 2B continues the example of Figure 2A, and illustrates two additional perspective images, including an additional perspective image 250b taken in a northwesterly direction from acquisition location 210B in the living room of house 198 of Figure 1 - the directional indicator 109b is further displayed to illustrate the northwesterly direction in which the image is taken. In this example image, a small portion of one of the windows 196-1 continues to be visible, along with a portion of window 196-2 and a new lighting fixture 130b. In addition, horizontal and vertical room borders are visible in image 250b in a manner similar to that of Figure 2A. Figure 2B further illustrates a third perspective image 250c taken in a southwesterly direction in the living room of house 198 of Figure 1, such as from acquisition location 210B - the directional indicator 109c is further displayed to illustrate the southwesterly direction in which the image is taken. In this example image, a portion of window 196-2 continues to be visible, as is a couch 191 and visual horizontal and vertical room borders in a manner similar to that of Figures 2A and 2B. This example image further illustrates two inter-room passages for the living room, which in this example include a doorway 190-1 with a swinging door to enter and leave the living room (which Figure 1 identifies as a door to the exterior of the house, such as the front yard), and a doorway 190-6 with a sliding door to move between the living room and side yard 188 - as is shown in the information in Figure 1, an additional non-doorway wall opening 263a exists in the east wall of the living room to move between the living room and hallway, but is not visible in the images 250a-250c. It will be appreciated that a variety of other perspective images may be taken from acquisition location 210B and/or other acquisition locations and displayed in a similar manner.

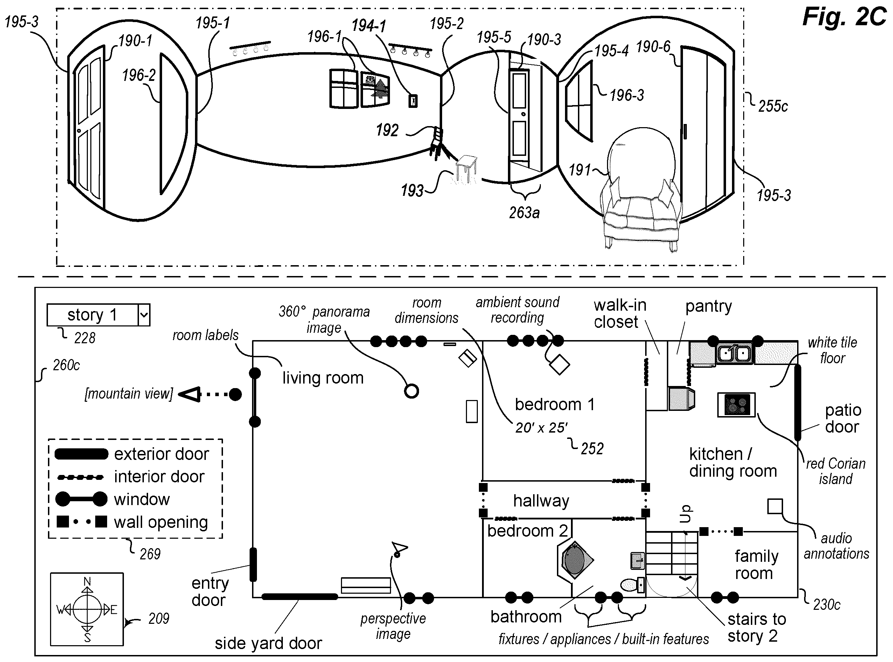

Figure 2C continues the examples of Figures 2A-2B, and illustrates a 360° panorama image 255c (*e.g.,* taken from acquisition location 210B), which displays the entire living room in an equirectangular format - since the panorama image does not have a direction in the same manner as the perspective images of Figures 2A-2B, the directional indicator 109 is not displayed in Figure 2C, although a pose for the panorama image may include one or more associated directions (*e.g.,* a starting and/or ending direction for the panorama image, such as if acquired via rotation). A portion of the visual data of panorama image 255c corresponds to the first perspective image 250a (shown in approximately the center portion of the image 250d), while the left portion of the image 255c and the far-right portion of the image 255c contain visual data corresponding to those of the perspective images 250b and 250c. This example panorama image 255d includes windows 196-1, 196-2 and 196-3, furniture 191-193, doorways 190-1 and 190-6, and non-doorway wall opening 263a to the hallway room (with the opening showing part of a door 190-3 visible in the adjacent hallway). Image 255c further illustrates a variety of room borders in a manner similar to that of the perspective images, but with the horizontal borders displayed in an increasingly curved manner as distance from the image's horizontal midline increases - borders include vertical inter-wall borders 195-1 through 195-4, vertical border 195-5 at the north/left side of the hallway opening, vertical borders at the right side of the hallway opening, and horizontal borders between the walls and the floor and between the walls and the ceiling.

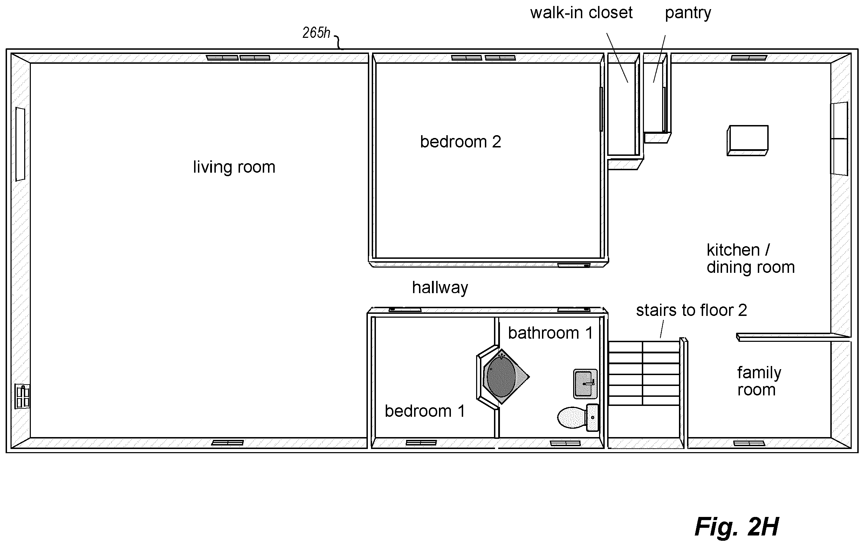

Figure 2C further illustrates one example of a 2D floor plan 230c for the house 198, such as may be generated by a MIGM system and presented to an end-user in a GUI 260c, with the living room being the most westward room of the house (as reflected by directional indicator 209) - it will be appreciated that a 3D or 2.5D floor plan building model with rendered wall height information may be similarly generated and displayed in some embodiments, whether in addition to or instead of such a 2D floor plan, with one example of such a floor plan building model illustrated in Figure 2H. Various types of information are illustrated on the 2D floor plan 230c in this example. For example, such types of information may include one or more of the following: room labels added to some or all rooms (*e.g.,* "living room" for the living room); room dimensions added for some or all rooms, such as based on building dimension information determined by the BOBSDM system; visual indications of features such as installed fixtures or appliances (*e.g.,* kitchen appliances, bathroom items, etc.) or other built-in elements (*e.g.,* a kitchen island) added for some or all rooms; visual indications added for some or all rooms of positions of additional types of associated and linked information (*e.g.,* of other panorama images and/or perspective images that an end-user may select for further display, of audio annotations and/or sound recordings that an end-user may select for further presentation, etc.); visual indications added for some or all rooms of structural features such as doors and windows; visual indications of visual appearance information (*e.g.,* color and/or material type and/or texture for installed items such as floor coverings or wall coverings or surface coverings); visual indications of views from particular windows or other building locations and/or of other information external to the building (*e.g.,* a type of an external space; items present in an external space; other associated buildings or structures, such as sheds, garages, pools, decks, patios, walkways, gardens, etc.); a key or legend 269 identifying visual indicators used for one or more types of information; etc. When displayed as part of a GUI, some or all such illustrated information may be user-selectable controls (or be associated with such controls) that allows an end-user to select and display some or all of the associated information (*e.g*., to select the 360° panorama image indicator for acquisition location 210B to view some or all of that panorama image (*e.g.,* in a manner similar to that of Figures 2A-2C). In addition, in this example a user-selectable control 221 is added to indicate a current story that is displayed for the floor plan, and to allow the end-user to select a different story to be displayed - in some embodiments, a change in stories or other levels may also be made directly from the floor plan, such as via selection of a corresponding connecting passage in the illustrated floor plan (*e.g.,* the stairs to story 2), and other visual changes may be made directly from the displayed floor plan by selecting corresponding displayed user-selectable controls (*e.g.,* to select a control corresponding to a particular image at a particular location, and to receive a display of that image, whether instead of or in addition to the previous display of the floor plan from which the image is selected). In other embodiments, information for some or all different floors may be displayed simultaneously, such as by displaying separate sub-floor plans for separate floors, or instead by integrating the room connection information for all rooms and floors into a single floor plan that is shown together at once. It will be appreciated that a variety of other types of information may be added in some embodiments, that some of the illustrated types of information may not be provided in some embodiments, and that visual indications of and user selections of linked and associated information may be displayed and selected in other manners in other embodiments.

Figure 2D continues the examples of Figures 2A-2C, and illustrates additional information about the living room and about analyzing 360° images captured in the living room (*e.g.,* for target panorama images captured at two or more of acquisition locations 210A, 210B and 210C) as part of determining one type of estimate of a partial likely shape of the room, such as by the MIGM system. In particular, Figure 2D includes information 255de illustrating that a 360° image taken from location 240b in living room 201 will share information about a variety of visible 2D features with that of a 360° image taken from location 240a, although only a limited subset of such features are illustrated in Figure 2D for a portion of the living room for the sake of simplicity. In Figure 2D, example lines of sight 228 from location 240b to various example features in the room are shown, and similar example lines of sight 227 from location 240a to corresponding features are shown, which illustrate degrees of difference between the views at significantly spaced capture locations. Figure 2D further illustrates information 255df about the northeast portion of the living room that is visible in subsets of 360° images taken from locations 240a and 240b (*e.g.,* video frames taken along a sequence of locations 240), and information 255dg about the northwest portion of the living room that is visible in other subsets of 360° images taken from locations 240a and 240b, with various example features in those portions of the living room being visible in both 360° image frames (*e.g.,* corners 195-1 and 195-2, windows 196-1 and 196-2, etc.). As part of the automated analysis of the 360° images, partial information about planes 286e and 286f corresponding to portions of the northern wall of the living room may be determined from the features that are detected, and partial information 287e and 285f about portions of the east and west walls of the living room may be similarly determined from corresponding features identified in the images. In addition to identifying such partial plane information for detected features (*e.g.,* for each point in a determined sparse 3D point cloud from the image analysis), the automated techniques (optionally including SLAM and/or MVS and/or SfM techniques) may further determine information about likely locations and orientations/directions 220 for the image subsets from capture location 240a, and likely locations and orientations/directions 222 for the image subsets from capture location 240b (*e.g.,* locations 220g and 222g of the capture locations 240a and 240b, respectively, and optionally directions 220e and 222e for the image subsets shown in 255df; and corresponding locations 220g and 222g of the capture locations 240a and 240b, respectively, and optionally directions 220f and 222f for the image subsets shown in 255dg). While only features for part of the living room are illustrated in Figure 2D, it will be appreciated that the other portions of the 360° images corresponding to other portions of the living room may be analyzed in a similar manner, in order to determine possible information about possible planes for the various walls of the room, as well as for other features (not shown) in the living room. Similar analyses may be performed between some or all other images at locations 215 in the living room that are selected for use, resulting in a variety of determined feature planes from the various image analyses that may correspond to portions of the walls of the room.

Figure 2D further illustrates information 255dh about a variety of determined feature planes that may correspond to portions of the west and north walls of the living room, from analyses of the 360° images captured at locations 240a and 240b. The illustrated plane information includes determined planes 286g near or at the northern wall (and thus corresponding possible locations of parts of the northern wall), and determined planes 285g near or at the western wall (and thus corresponding possible locations of parts of the western wall). As would be expected, there are a number of variations in different determined planes for the northern and western walls from different features detected in the analysis of the two 360° images, such as differences in position, angle and/or length, as well as missing data for some portions of the walls, causing uncertainty as to the actual exact position and angle of each of the walls. While not illustrated in Figure 2D, it will be appreciated that similar determined feature planes for the other walls of the living room would similarly be detected, along with determined feature planes corresponding to features that are not along the walls (*e.g.,* furniture). Figure 2D further illustrates information 255di about additional determined feature plane information that may correspond to portions of the west and north walls of the living room, from analyses of various additional 360° images in the living room - as would be expected, the analyses of the further images provides even greater variations in different determined planes for the northern and western walls in this example. Figure 2D further illustrates additional determined information that is used to aggregate information about the various determined feature planes portions in order to identify likely partial locations 295a and 295b of the west and north walls, as illustrated in information 255dj of Figure 2D. In particular, Figure 2D illustrates information 291a about normal orthogonal directions for some of the determined feature planes corresponding to the west wall, along with additional information 288a about those determined feature planes. In the example embodiment, the determined feature planes are clustered to represent hypothesized wall locations of the west wall, and the information about the hypothesized wall locations is combined to determine the likely wall location 295a, such as by weighting information from the various clusters and/or the underlying determined feature planes. In at least some embodiments, the hypothesized wall locations and/or normal information is analyzed via use of machine learning techniques to determine the resulting likely wall location, optionally by further applying assumptions or other constraints (such as a 90° corner, as illustrated in information 289 of Figure 2D, and/or having flat walls) as part of the machine learning analysis or to results of the analysis. Similar analysis may be performed for the north wall using information 288b about corresponding determined feature planes and additional information 291b about resulting normal orthogonal directions for at least some of those determined feature planes. Figure 2D illustrates the resulting likely partial wall locations 295a and 295b for west and north walls of the living room, respectively.

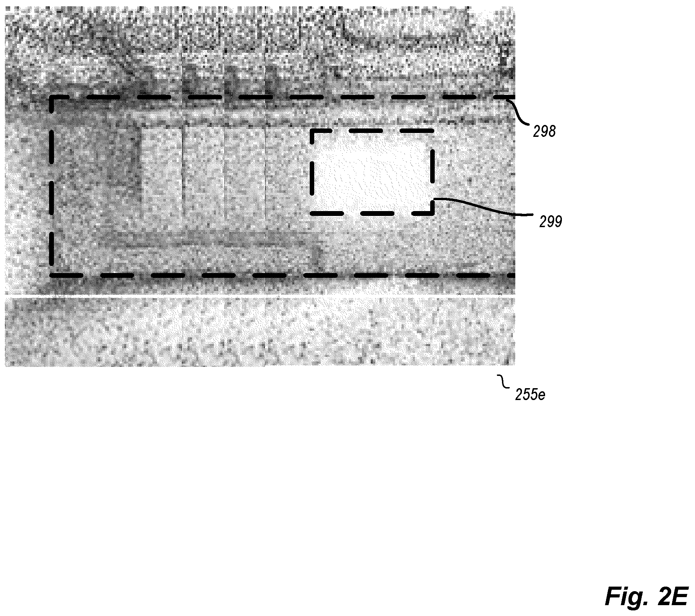

While not illustrated in Figure 2D, it will be appreciated that similar determined feature planes and corresponding normal directions for the other walls of the living room will similarly be detected and analyzed to determine their likely locations, resulting in an estimated partial overall room shape for the living room that is based on visual data acquired by the one or more image acquisition devices in the living room. In addition, similar analyses are performed for each of the rooms of the building, providing estimated partial room shapes of each of the rooms. While not illustrated in Figure 2D, other room shape estimation operations may be performed in at least some embodiments using only a single target panorama image, such as via an analysis of the visual data of that target panorama image by one or more trained neural networks, as discussed in greater detail elsewhere herein. Furthermore, while also not illustrated in Figure 2D, the analysis of the visual data captured by the one or more image acquisition devices may be supplemented and/or replaced in some embodiments by analysis of depth data (not shown) captured by the one or more image acquisition devices in the living room, such as to directly generate an estimated 3D point cloud from the depth data that represents the walls and optionally ceiling and/or floor of the living room, such as illustrated in Figure 2E. In particular, Figure 2E continues the examples of Figures 2A-2D, and illustrates information 255e about additional information that may be generated from one or more images in a room and used in one or more manners in at least some embodiments. In particular, images (*e.g.,* video frames) captured in the living room of the house 198 may be analyzed in order to determine an estimated 3D shape of the living room, such as from a 3D point cloud of features detected in the video frames (*e.g.,* using SLAM and/or SfM and/or MVS techniques, and optionally further based on IMU data captured by the one or more image acquisition devices). In this example, information 255e reflects an example portion of such a point cloud for the living room, such as in this example to correspond to a northwesterly portion of the living room (*e.g.,* to include northwest corner 195-1 of the living room, as well as windows 196-1) in a manner similar to image 250c of Figure 2B. Such a point cloud may be further analyzed to detect features such as windows, doorways and other inter-room openings, etc. - in this example, an area 299 corresponding to windows 196-1 is identified, as well as borders 298 corresponding to the north wall of the living room. It will be appreciated that in other embodiments such an estimated 3D shape of the living room may be determined by using depth data captured by the one or more image acquisition devices in the living room, whether in addition to or instead of using visual data of one or more images captured by the one or more image acquisition devices in the living room. In addition, it will be appreciated that various other walls and other features may be similarity identified in the living room and in the other rooms of the house 198.

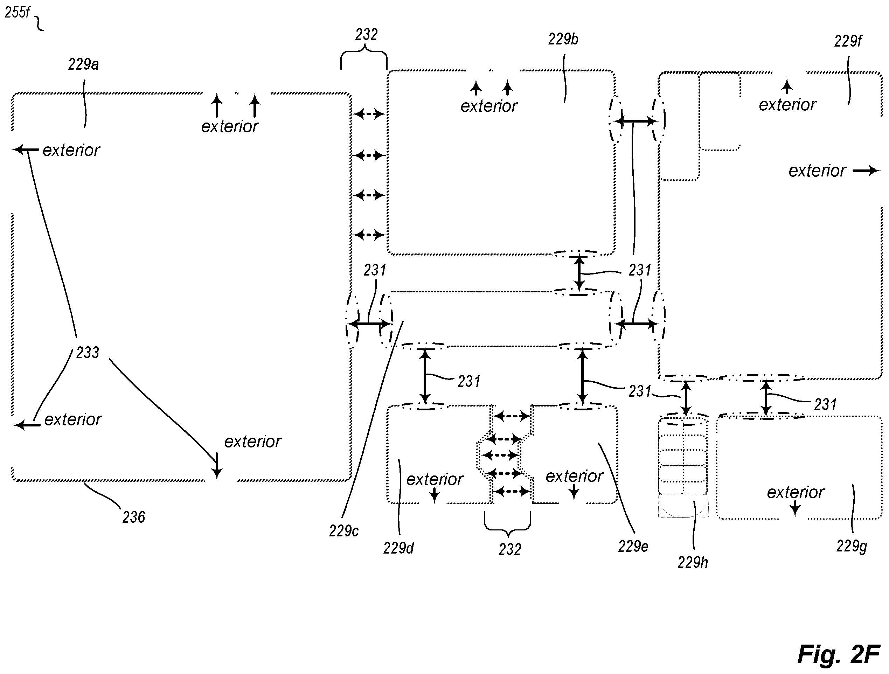

Figure 2F continues the examples of Figures 2A-2E, and illustrates additional information 255f corresponding to, after final estimated room shapes are determined for the rooms of the illustrated floor of the house 198 (*e.g.,* 2D room shape 236 for the living room), positioning the rooms' estimated room shapes relative to each other, based at least in part in this example on connecting inter-room passages between rooms and matching room shape information between adjoining rooms - in at least some embodiments, such information may be treated as constraints on the positioning of the rooms, and an optimal or otherwise preferred solution is determined for those constraints. Examples of such constraints in Figure 2F include matching 231 connecting passage information (*e.g.,* passages detected in the automated image analyses discussed with respect to Figure 2D) for adjacent rooms so that the locations of those passages are co-located, and matching 232 shapes of adjacent rooms in order to connect those shapes (*e.g.,* as shown for rooms 229d and 229e, and for rooms 229a and 229b). Various other types of information may be used in other embodiments for room shape positions, whether in addition to or instead of passage-based constraints and/or room shape-based constraints, such as exact or approximate dimensions for an overall size of the house (*e.g.,* based on additional metadata available regarding the building, analysis of images from one or more image acquisition locations external to the building, etc.). Exterior information 233 outside of the house may further be identified and used as constraints (*e.g.,* based at least in part of automated identification of passages and other features corresponding to the building exterior, such as windows), such as to prevent another room from being placed at a location that has been identified as the building's exterior. In the example of Figure 2F, the final estimated room shapes that are used may be 2D room shapes, or instead 2D versions of 3D final estimated room shapes may be generated and used (*e.g.,* by taking a horizontal slice of a 3D room shape).

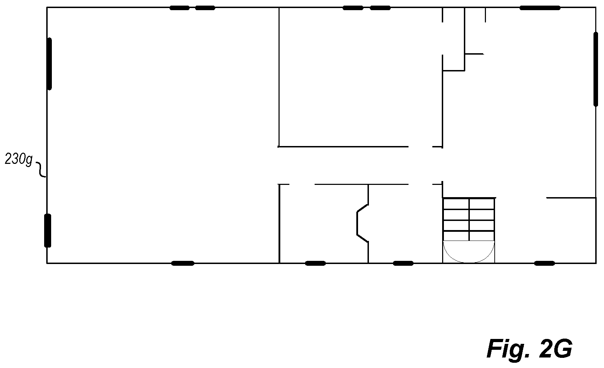

Figures 2G and 2H continue the examples of Figure 2A-2F, and illustrate mapping information that may be generated from the types of analyses discussed in Figures 2D-2F. In particular, Figure 2G illustrates an example floor plan 230g that may be constructed based on the positioning of determined final estimated room shapes, which in this example includes walls and indications of doorways and windows, and before the determination and addition of further building information as shown in floor plan 230c of Figure 2C. Figure 2H illustrates additional information 265h that may be generated from the automated analysis techniques disclosed herein, and displayed (*e.g.,* in a GUI similar to that of Figure 2C), which in this example is a 2.5D or 3D model floor plan of the house. Such a model 265h may be additional mapping-related information that is generated based on the floor plan 230g, with additional information about height shown in order to illustrate visual locations in walls of features such as windows and doors, or instead by combining final estimated room shapes that are 3D shapes. While not illustrated in Figure 2H, various types of additional information may be determined for the building and added to the floor plan model 265h in some embodiments and situations, such as the types of information illustrated for floor place 230c of Figure 2C. In addition, further information may be added to the displayed walls in some embodiments, such as from images taken during the video capture (*e.g.,* to render and illustrate actual paint, wallpaper or other surfaces from the house on the rendered model 265), and/or may otherwise be used to add specified colors, textures or other visual information to walls and/or other surfaces.

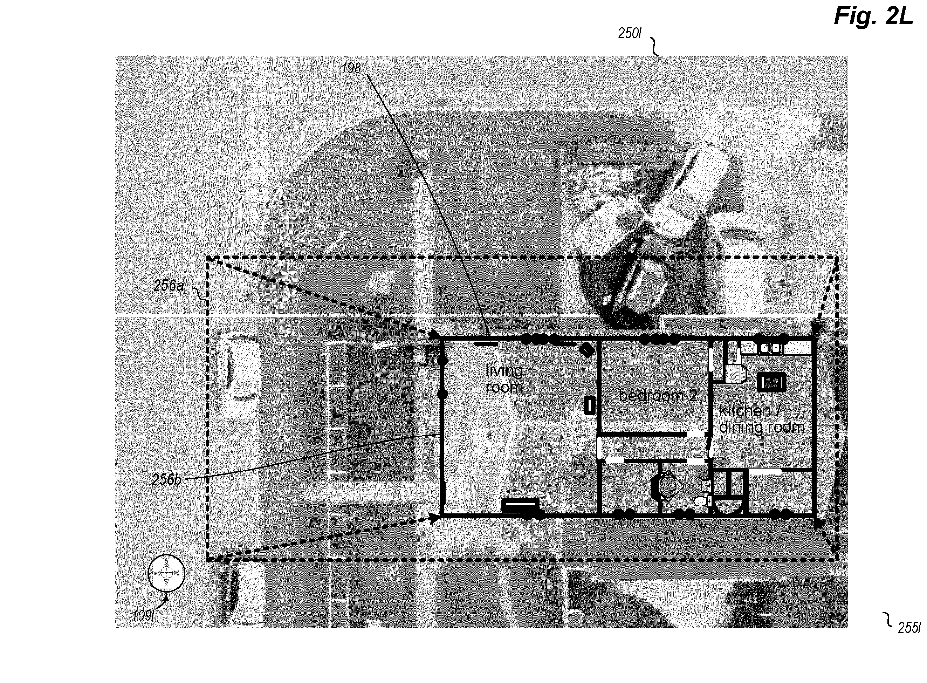

Figure 2I continues the examples of Figures 2A-2H, and illustrates information 255i that shows an example of identifying objects of a defined type in an image, and using standardized or otherwise expected sizes for objects of those types to determine estimated camera height and other scaling information for the image. In this example, the image is panorama image 255c in equirectangular format from Figure 2C, and the defined type of object is a doorway, with swinging doorway 190-1 and sliding doorway 190-6 being visible in the living room - the BOBSDM system has analyzed the visual data of the image to identify the two doorways, and has further determined additional information about the doorways, including to identify the four corners marked A, B, C, and D and the bottom 264b-1 and top 264a-i1 for doorway 190-1, and has similarly identified the top and bottom 264a-i2 and 264b-i2 and four corners (not shown) for doorway 190-6. In the illustrated embodiment, the BOBSDM system uses an assumed doorway height 254-i1 of 80 inches (or 2.03m) for doorway 190-1, and desires to determine a portion of that height H1 that corresponds to the estimated camera height above the floor when capturing the image, with the additional height H2 being the difference between the 80-inch height and the estimated camera height. As illustrated in information 252 of Figure 2I, the corners may be initially represented in coordinates local to the image, such as to represent the lower left corner A as (x1, 1, z1), and then may be transformed into real world coordinates by using the illustrated formula to calculate the estimated camera height H1. A different estimated camera height H1' (not shown) may similarly be determined for doorway 190-6 using the same expected height of 80 inches for the height 254-i2 of that doorway, and the two estimated camera heights H1 and H1' may in some embodiments be combined to determine a single final estimated camera height for the image 255c, such as to determine a mean or other average of the two heights if the different estimated camera heights satisfy one or more defined validation criteria (*e.g.,* differ by at most a defined threshold amount), and to otherwise use an alternative technique for determining building dimension information as discussed in Figure 2L. In addition, while not illustrated in Figure 2I, other objects of other defined types (*e.g.,* floor cabinets) that are visible in the same image may similarly be analyzed to determine other individual estimates of the camera height using standardized or otherwise expected heights of those other object types (*e.g.,* 36 inches for floor cabinets), and if so the final estimated camera height for image 255c may be further based on those other additional individual estimated camera heights as well if the different estimated camera heights satisfy one or more defined validation criteria (*e.g.,* differ by at most a defined threshold amount), although such other object types are not shown in this example. Furthermore, while not illustrated in Figure 2I, similar estimated camera heights may be determined for objects in other images captured during the same image acquisition session, such as other doorways and/or other objects of other defined types, and if so the final estimated camera height for image 255c may be further based on those other additional individual estimated camera heights as well if the different estimated camera heights satisfy one or more defined validation criteria (*e.g.,* differ by at most a defined threshold amount), although such other images and associated other objects are not shown in this example. Once the estimated camera height is determined, actual distances may then be determined and assigned to other objects and elements visible in the image, such as the width of doorway 190-1, the height and width/length 253-i1 of the picture window on the left wall of the living room, the width/length 253-i2 of the north wall of the living room, etc. - by determining at least the width/length of each of the walls, dimensions for a 2D room shape for the living room that is generated from the visual data of the image may be determined, and if height information is further determined for one or more of the walls, dimensions for a 3D room shape for the living room may similarly be determined.

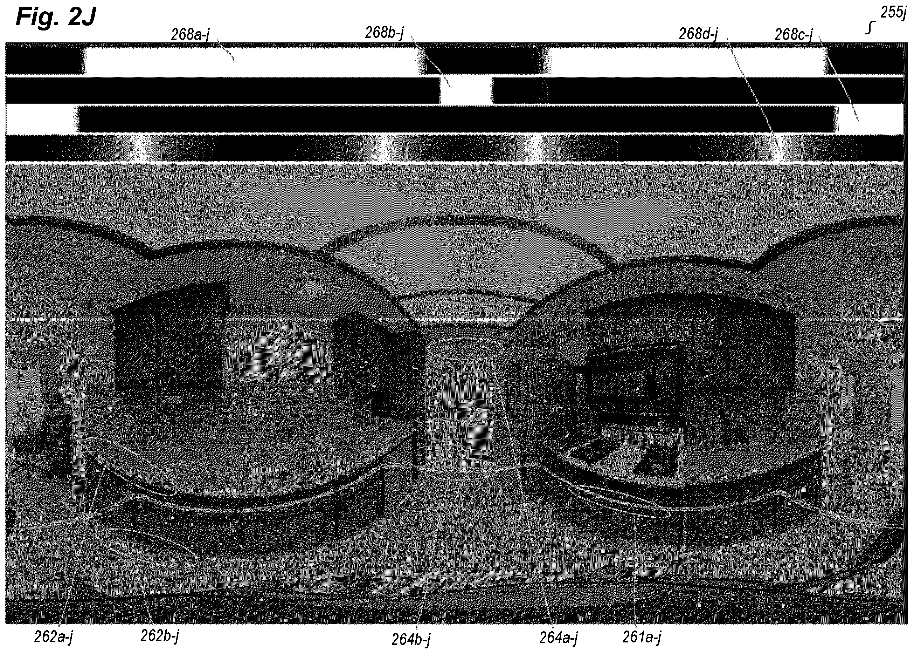

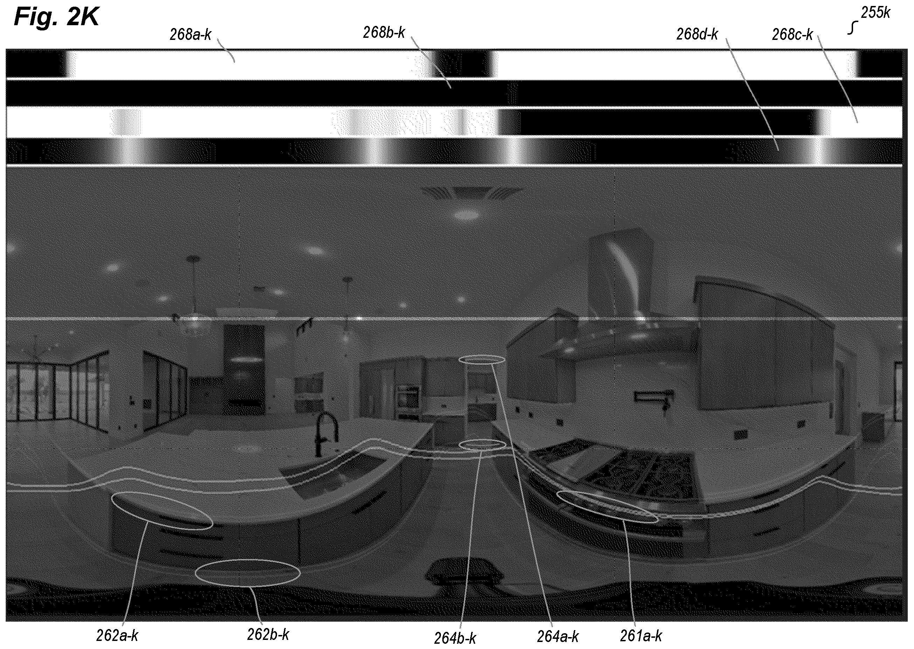

Figures 2J and 2K continue the examples of Figures 2A-2I, and illustrate information 255j and 255k that shows additional examples of identifying objects of defined types in other images. In particular, with respect to Figure 2J, several floor cabinets are shown, and the BOBSDM system has identified the tops 262a-j and bottoms 262b-j of those cabinets, as well as additional information 261a-j to represent the floor-to-wall boundary, and the bottom 264b-j and top 264a-j of a visible doorway. As discussed in greater detail elsewhere herein, and in a manner analogous to that of Figure 2I, the BOBSDM system may determine a first estimated camera height using the information shown for the visible doorway, and may determine one or more second estimated camera heights for the visible floor cabinets, such as one estimated camera height for each cabinet, one estimated camera height for each pixel column in which the floor cabinets are visible, etc. As discussed with respect to Figure 2I and elsewhere herein, the estimated camera heights for the various visible objects of the defined types may then be combined to determine the final estimate camera height for at least the current image (and optionally for additional images captured during the same image acquisition session, including by further combining estimated camera heights determined from objects of one or more defined types visible in those other images). Figure 2K provides another example of identifying objects of one or more defined types, with the illustrated example including various floor cabinets and an identified doorway, and with the BOBSDM system identifying the tops 262a-k and bottoms 262b-k of the floor cabinets, a floor-to-wall border 261a-k, and a top and bottom 264a-k and 264b-k of the visible doorway.

Figure 2L continues the examples of Figures 2A-2K, and illustrates information 255I regarding an alternative technique for determining dimensions of the building and its rooms, such as in situations in which an estimated camera height is not determined from analysis of one or more images (*e.g.,* if different individual estimated camera heights for multiple objects of one or more defined object types differ by more than a defined threshold amount or otherwise do not satisfy one or more defined validation criteria). In the illustrated example, an overhead image 250I of the building 198 has been obtained (*e.g.,* from a drone or satellite), and a floor plan for the building has been generated (*e.g.,* from analysis of visual data of the images captured in and around the building). The automated techniques of the BOBSDM system include fitting the exterior of at least part of the overall building floor plan (*e.g.,* a partial building floor plan for the first story) to the visible exterior of the building in the image, such as by starting with a size 256a of the floor plan and reducing it until a fit 256b is achieved. It will be appreciated that the fitting may be performed in other manners in other embodiments, including to begin with a visual representation of the floor plan that is smaller than the visible exterior of the building in the image and increasing it in size, as well as performing rotations and other manipulations if the image is not captured from directly overhead and aligned with the same directional information used for the floor plan.

Various details have been provided with respect to Figures 2A-2L, but it will be appreciated that the provided details are non-exclusive examples included for illustrative purposes, and other embodiments may be performed in other manners without some or all such details.

As noted above, in some embodiments, the described techniques include using machine learning to learn the attributes and/or other characteristics of adjacency graphs to encode in corresponding vector embeddings that are generated, such as the attributes and/or other characteristics that best enable subsequent automated identification of building floor plans having attributes satisfying target criteria, and with the vector embeddings that are used in at least some embodiments to identify target building floor plans being encoded based on such learned attributes or other characteristics. In particular, in at least some such embodiments, graph representation learning is used to search for a mapping function that can map the nodes in a graph to d-dimensional vectors, such that in the learned space similar nodes in the graph have similar embeddings. Unlike traditional methods such as graph kernel methods (see, *for example,* "Graph Kernels" by S.V.N. Vishwanathan et al., Journal of Machine Learning Research, 11:1201-1242, 2010; and "A Survey On Graph Kernels", Nils M. Kriege et al., arXiv:1903.11835, 2019), graph neural networks remove the process of hand-engineered features and directly learn the high-level embeddings from the raw features of nodes or the (sub)graph. Various techniques exist for extending and re-defining convolutions in the graph domain, which can be categorized into the spectral approach and the spatial approach. The spectral approach employs the spectral representation of a graph, and are specific to a particular graph structure, such that the models trained on one graph are not applicable to a graph with a different structure (see, *for example,* "Spectral Networks And Locally Connected Networks On Graphs", Joan Bruna et al., International Conference on Learning Representations 2014, 2014; "Convolutional Neural Networks On Graphs With Fast Localized Spectral Filtering", Michael Defferrard et al., Proceedings of Neural Information Processing Systems 2016, 2016, pp. 3844-3852; and "Semi-Supervised Classification With Graph Convolutional Networks", Thomas N. Kipf et al., International Conference on Learning Representations 2017, 2017). The convolution operation for the spectral approach is defined in the Fourier domain by computing the eigendecomposition of the graph Laplacian, and the filter may be approximated to reduce the expensive eigen-decomposition by Chebyshev expansion of graph Lapacian, generating local filters, with the filters optionally limited to work on neighbors one step away from the current node. With respect to the spatial approach, it includes learning embeddings for a node by recursively aggregating information from its local neighbors. Various amounts of neighboring nodes and corresponding aggregation functions can be handled in various ways. For example, a fixed number of neighbors for each node may be sample, and different aggregation functions such as mean, max and long short term memory networks (LSTM) may be used (see, *for example,* "Inductive Representation Learning On Large Graphs", Will Hamilton et al., Proceedings of Neural Information Processing Systems 2017, 2017, pp. 1024-1034). Alternatively, each neighboring node may be considered to contribute differently to a central node, with the contribution factors being learnable via self-attention models (see, *for example,* "Graph Attention Networks", P. Velickovic et al., International Conference on Learning Representations 2018, 2018). Furthermore, each attention head captures feature correlation in a different representation subspace, and may be treated differently, such as by using a convolutional sub-network to weight the importance of each attention head (see, *for example,* "GaAN: Gated Attention Networks For Learning On Large And Spatiotemporal Graphs", Jiani Zhang et al., Proceedings of Uncertainty in Artificial Intelligence 2018, 2018).

In addition, in some embodiments, the creation of an adjacency graph and/or associated vector embedding for a building may be further based in part on partial information that is provided for the building (*e.g.,* by an operator user of the BOBSDM system, by one or more end users, etc.). Such partial information may include, for example, one or more of the following: some or all room names for rooms of the building being provided, with the connections between the rooms to be automatically determined or otherwise established; some or all inter-room connections between rooms of the building being provided, with likely room names for the rooms to be automatically determined or otherwise established; some room names and inter-room connections being provided, with the other inter-room connections and/or likely room names to be automatically determined or otherwise established. In such embodiments, the automated techniques may include using the partial information as part of completing or otherwise generating a building floor plan, with the floor plan subsequently used for creating a corresponding adjacency graph and/or vector embedding.

Figure 3 is a block diagram illustrating an embodiment of one or more server computing systems 300 executing an implementation of a BOBSDM system 340, and one or more server computing systems 380 executing an implementation of an ICA system 388 and an MIGM system 389 - the server computing system(s) and BOBSDM and/or ICA and/or MIGM systems may be implemented using a plurality of hardware components that form electronic circuits suitable for and configured to, when in combined operation, perform at least some of the techniques described herein. One or more computing systems and devices may also optionally be executing a Building Information Access system, not shown (such as server computing system(s) 300, client computing device(s) 390, etc.) and/or optional other programs 335 and 383 (such as server computing system(s) 300 and 380, respectively, in this example). In the illustrated embodiment, each server computing system 300 includes one or more hardware central processing units ("CPUs") or other hardware processors 305, various input/output ("I/O") components 310, storage 320, and memory 330, with the illustrated I/O components including a display 311, a network connection 312, a computer-readable media drive 313, and other I/O devices 315 (*e.g.,* keyboards, mice or other pointing devices, microphones, speakers, GPS receivers, etc.). Each server computing system 380 may have similar components, although only one or more hardware processors 381, memory 387, storage 384 and I/O components 382 are illustrated in this example for the sake of brevity.

In the illustrated embodiment, the BOBSDM system 340 executes in memory 330 of the server computing system(s) 300 in order to perform at least some of the described techniques, such as by using the processor(s) 305 to execute software instructions of the system 340 in a manner that configures the processor(s) 305 and computing system 300 to perform automated operations that implement those described techniques. The illustrated embodiment of the BOBSDM system may include one or more components, not shown, to each perform portions of the functionality of the BOBSDM system, such as in a manner discussed elsewhere herein, and the memory may further optionally execute one or more other programs 335 - as one specific example, a copy of the ICA and/or MIGM systems may execute as one of the other programs 335 in at least some embodiments, such as instead of or in addition to the ICA and/or MIGM systems 388-389 on the server computing system(s) 380, and/or a copy of a Building Information Access system may execute as one of the other programs 335. The BOBSDM system 340 may further, during its operation, store and/or retrieve various types of data on storage 320 (*e.g.,* in one or more databases or other data structures), such as information 326 about identified target objects (*e.g.,* doorways and floor cabinets) and other objects/elements from analysis of building images, determined camera height estimations and other image scaling information 325, determined building dimension information 327 (*e.g.,* dimensions of target objects and other visible objects/elements, walls, rooms, the building as a whole, etc.), floor plans and images and other associated information 324 (*e.g.,* images captured and/or generated by the ICA system; 2D and/or 2.5D and/or 3D models generated by the MIGM system; building and room dimensions for use with associated floor plans, such as generated by the BOBSDM system; additional images and/or annotation information; etc.), optionally various types of user information 322 for users who interact with the BOBSDM system, and/or various types of optional additional information 329 (*e.g.,* various analytical information related to presentation or other use of one or more building interiors or other environments).

In addition, embodiments of the ICA and MIGM systems 388-389 execute in memory 387 of the server computing system(s) 380 in the illustrated embodiment in order to perform techniques related to generating panorama images and floor plans for buildings, such as by using the processor(s) 381 to execute software instructions of the systems 388 and/or 389 in a manner that configures the processor(s) 381 and computing system(s) 380 to perform automated operations that implement those techniques. The illustrated embodiment of the ICA and MIGM systems may include one or more components, not shown, to each perform portions of the functionality of the ICA and MIGM systems, respectively, and the memory may further optionally execute one or more other programs 383. The ICA and/or MIGM systems 388-389 may further, during operation, store and/or retrieve various types of data on storage 384 (*e.g.,* in one or more databases or other data structures), such as video and/or image information 386 acquired for one or more buildings (*e.g.,* 360° video or images for analysis to generate floor plans, to provide to users of client computing devices 390 for display, etc.), floor plans and/or other generated mapping information 387, and optionally other information 385 (*e.g.,* additional images and/or annotation information for use with associated floor plans, building and room dimensions for use with associated floor plans, various analytical information related to presentation or other use of one or more building interiors or other environments, etc.) - while not illustrated in Figure 3, the ICA and/or MIGM systems may further store and use additional types of information, such as about other types of building information to be analyzed and/or provided to the BOBSDM system, about ICA and/or MIGM system operator users and/or end-users, etc.

The server computing system(s) 300 and executing BOBSDM system 340, server computing system(s) 380 and executing ICA and MIGM systems 388-389, and optionally executing Building Information Access system (not shown), may communicate with each other and with other computing systems and devices in this illustrated embodiment, such as via one or more networks 399 (*e.g.,* the Internet, one or more cellular telephone networks, etc.), including to interact with user client computing devices 390 (*e.g.,* used to view floor plans, and optionally associated images and/or other related information, such as by interacting with or executing a copy of the Building Information Access system), and/or mobile image acquisition devices 360 (*e.g.,* used to acquire images and/or other information for buildings or other environments to be modeled), and/or optionally other navigable devices 395 that receive and use floor plans and optionally other generated information for navigation purposes (*e.g.,* for use by semi-autonomous or fully autonomous vehicles or other devices). In other embodiments, some of the described functionality may be combined in less computing systems, such as to combine the BOBSDM system 340 and a Building Information Access system in a single system or device, to combine the BOBSDM system 340 and the image acquisition functionality of device(s) 360 in a single system or device, to combine the ICA and MIGM systems 388-389 and the image acquisition functionality of device(s) 360 in a single system or device, to combine the BOBSDM system 340 and the ICA and MIGM systems 388-389 in a single system or device, to combine the BOBSDM system 340 and the ICA and MIGM systems 388-389 and the image acquisition functionality of device(s) 360 in a single system or device, etc.

Some or all of the user client computing devices 390 (*e.g.,* mobile devices), mobile image acquisition devices 360, optional other navigable devices 395 and other computing systems (not shown) may similarly include some or all of the same types of components illustrated for server computing system 300. As one non-limiting example, the mobile image acquisition devices 360 are each shown to include one or more hardware CPU(s) 361, I/O components 362, memory and/or storage 367, one or more imaging systems 365, IMU hardware sensors 369 (*e.g.,* for use in acquisition of video and/or images, associated device movement data, etc.), and optionally other components 364. In the illustrated example, one or both of a browser and one or more client applications 368 (*e.g.,* an application specific to the BOBSDM system and/or to ICA system and/or to the MIGM system) are executing in memory 367, such as to participate in communication with the BOBSDM system 340, ICA system 388, MIGM system 389 and/or other computing systems. While particular components are not illustrated for the other navigable devices 395 or other computing devices/systems 390, it will be appreciated that they may include similar and/or additional components.

It will also be appreciated that computing systems 300 and 380 and the other systems and devices included within Figure 3 are merely illustrative and are not intended to limit the scope of the present invention. The systems and/or devices may instead each include multiple interacting computing systems or devices, and may be connected to other devices that are not specifically illustrated, including via Bluetooth communication or other direct communication, through one or more networks such as the Internet, via the Web, or via one or more private networks (*e.g.,* mobile communication networks, etc.). More generally, a device or other computing system may comprise any combination of hardware that may interact and perform the described types of functionality, optionally when programmed or otherwise configured with particular software instructions and/or data structures, including without limitation desktop or other computers (*e.g.,* tablets, slates, etc.), database servers, network storage devices and other network devices, smart phones and other cell phones, consumer electronics, wearable devices, digital music player devices, handheld gaming devices, PDAs, wireless phones, Internet appliances, and various other consumer products that include appropriate communication capabilities. In addition, the functionality provided by the illustrated BOBSDM system 340 may in some embodiments be distributed in various components, some of the described functionality of the BOBSDM system 340 may not be provided, and/or other additional functionality may be provided.

It will also be appreciated that, while various items are illustrated as being stored in memory or on storage while being used, these items or portions of them may be transferred between memory and other storage devices for purposes of memory management and data integrity. Alternatively, in other embodiments some or all of the software components and/or systems may execute in memory on another device and communicate with the illustrated computing systems via inter-computer communication. Thus, in some embodiments, some or all of the described techniques may be performed by hardware means that include one or more processors and/or memory and/or storage when configured by one or more software programs (*e.g.,* by the BOBSDM system 340 executing on server computing systems 300, by a Building Information Access system executing on server computing systems 300 or other computing systems/devices, etc.) and/or data structures, such as by execution of software instructions of the one or more software programs and/or by storage of such software instructions and/or data structures, and such as to perform algorithms as described in the flow charts and other disclosure herein. Furthermore, in some embodiments, some or all of the systems and/or components may be implemented or provided in other manners, such as by consisting of one or more means that are implemented partially or fully in firmware and/or hardware (*e.g.,* rather than as a means implemented in whole or in part by software instructions that configure a particular CPU or other processor), including, but not limited to, one or more application-specific integrated circuits (ASICs), standard integrated circuits, controllers (*e.g.,* by executing appropriate instructions, and including microcontrollers and/or embedded controllers), field-programmable gate arrays (FPGAs), complex programmable logic devices (CPLDs), etc. Some or all of the components, systems and data structures may also be stored (*e.g.,* as software instructions or structured data) on a non-transitory computer-readable storage mediums, such as a hard disk or flash drive or other non-volatile storage device, volatile or non-volatile memory (*e.g.,* RAM or flash RAM), a network storage device, or a portable media article (*e.g.,* a DVD disk, a CD disk, an optical disk, a flash memory device, etc.) to be read by an appropriate drive or via an appropriate connection. The systems, components and data structures may also in some embodiments be transmitted via generated data signals (*e.g.,* as part of a carrier wave or other analog or digital propagated signal) on a variety of computer-readable transmission mediums, including wireless-based and wired/cable-based mediums, and may take a variety of forms (*e.g.,* as part of a single or multiplexed analog signal, or as multiple discrete digital packets or frames). Such computer program products may also take other forms in other embodiments. Accordingly, embodiments of the present disclosure may be practiced with other computer system configurations.

Figure 4 illustrates an example flow diagram of an embodiment of an ICA (Image Capture & Analysis) system routine 400. The routine may be performed by, for example, the ICA system 160 of Figure 1, the ICA system 388 of Figure 3, and/or an ICA system as described with respect to Figures 2A-2C and elsewhere herein, such as to acquire 360° panorama images and/or other images at acquisition locations within buildings or other structures, such as for use in subsequent generation of related floor plans and/or other mapping information. While portions of the example routine 400 are discussed with respect to acquiring particular types of images at particular acquisition locations, it will be appreciated that this or a similar routine may be used to acquire video (with video frame images) and/or other data (*e.g.,* audio), whether instead of or in addition to such panorama images or other perspective images. In addition, while the illustrated embodiment acquires and uses information from the interior of a target building, it will be appreciated that other embodiments may perform similar techniques for other types of data, including for non-building structures and/or for information external to one or more target buildings of interest. Furthermore, some or all of the routine may be executed on a mobile device used by a user to acquire image information, and/or by a system remote from such a mobile device. In at least some embodiments, the routine 400 may be invoked from block 512 of routine 500 of Figures 5A-5B, with corresponding information from routine 400 provided to routine 500 as part of implementation of that block 512 - in other embodiments, the routine 500 may proceed with additional operations in an asynchronous manner without waiting for such processing control to be returned (*e.g.,* to proceed with other processing activities while waiting for the corresponding information from the routine 400 to be provided to routine 500 in block 512).

The illustrated embodiment of the routine begins at block 405, where instructions or information are received. At block 410, the routine determines whether the received instructions or information indicate to acquire visual data and/or other data representing a building interior (optionally in accordance with supplied information about one or more additional acquisition locations and/or other guidance acquisition instructions), and if not continues to block 490. Otherwise, the routine proceeds to block 412 to receive an indication to begin the image acquisition process at a first acquisition location (*e.g.,* from a user of a mobile image acquisition device that will perform the acquisition process). After block 412, the routine proceeds to block 415 in order to perform acquisition location image acquisition activities for acquiring a 360° panorama image for the acquisition location in the interior of the target building of interest, such as via one or more fisheye lenses and/or non-fisheye rectilinear lenses on the mobile device and to provide horizontal coverage of at least 360° around a vertical axis, although in other embodiments other types of images and/or other types of data may be acquired. As one non-exclusive example, the mobile image acquisition device may be a rotating (scanning) panorama camera equipped with a fisheye lens (*e.g.,* with 180° degrees of horizontal coverage) and/or other lens (*e.g.,* with less than 180° degrees of horizontal coverage, such as a regular lens or wide-angle lens or ultrawide lens). The routine may also optionally obtain annotation and/or other information from the user regarding the acquisition location and/or the surrounding environment, such as for later use in presentation of information regarding that acquisition location and/or surrounding environment.

After block 415 is completed, the routine continues to block 425 to determine if there are more acquisition locations at which to acquire images, such as based on corresponding information provided by the user of the mobile device and/or received in block 405 - in some embodiments, the ICA routine will acquire only a single image and then proceed to perform blocks 430 and 440, followed by block 480 to provide that image and corresponding information (*e.g.,* to return the image and corresponding information to the MIGM system for further use before receiving additional instructions or information to acquire one or more next images at one or more next acquisition locations). If there are more acquisition locations at which to acquire additional images at the current time, the routine continues to block 427 to optionally initiate the capture of linking information during movement of the mobile device along a travel path away from the current acquisition location and towards a next acquisition location within the building interior - the captured linking information may include additional sensor data (*e.g.,* from one or more IMU, or inertial measurement units, on the mobile device or otherwise carried by the user) and/or additional visual information (*e.g.,* images, video, etc.) recorded during such movement. Initiating the capture of such linking information may be performed in response to an explicit indication from a user of the mobile device or based on one or more automated analyses of information recorded from the mobile device. In addition, the routine may further optionally monitor the motion of the mobile device in some embodiments during movement to the next acquisition location, and provide one or more guidance cues (*e.g.,* to the user) regarding the motion of the mobile device, quality of the sensor data and/or visual information being captured, associated lighting/environmental conditions, advisability of capturing a next acquisition location, and any other suitable aspects of capturing the linking information. Similarly, the routine may optionally obtain annotation and/or other information from the user regarding the travel path, such as for later use in presentation of information regarding that travel path or a resulting inter-panorama image connection link. In block 429, the routine determines that the mobile device has arrived at the next acquisition location (*e.g.,* based on an indication from the user, based on the forward movement of the mobile device stopping for at least a predefined amount of time, etc.), for use as the new current acquisition location, and returns to block 415 in order to perform the acquisition location image acquisition activities for the new current acquisition location.

If it is instead determined in block 425 that there are not any more acquisition locations at which to acquire image information for the current building or other structure at the current time, the routine proceeds to block 430 to optionally analyze information about the one or more acquisition locations to identify possible additional areas in the building for which to acquire visual data (*e*.*g*., based on not obtaining visual data for a kitchen or a bathroom, on only obtaining visual data for 2 bathrooms while textual description information for the building indicates 3 bathrooms, etc.) and/or other information to gather (*e*.*g*., audio data), and to optionally further provide user suggestions and/or directions if so identified and/or to otherwise assist in capturing corresponding additional data. In block 435, the routine then optionally preprocesses the acquired 360° panorama images before their subsequent use (*e*.*g*., for generating related mapping information, for providing information about features of rooms or other enclosing areas, etc.), such as to produce images of a particular type and/or in a particular format (*e*.*g*., to generate a straightened equirectangular projection for each such image, with straight vertical data such as the sides of a typical rectangular door frame or a typical border between 2 adjacent walls remaining straight, and with straight horizontal data such as the top of a typical rectangular door frame or a border between a wall and a floor remaining straight at a horizontal midline of the image but being increasingly curved in the equirectangular projection image in a convex manner relative to the horizontal midline as the distance increases in the image from the horizontal midline). After block 435, the routine continues to block 440 to perform a Building Object-Based Scale Determination Manager (BOBSDM) routine to determine estimated camera heights and optionally other scaling information for the images acquired in block 415 and to use that scaling information to determine building dimension information, with one example of such a routine further illustrated with respect to Figure 6. After the results of the BOBSM routine are received in block 440, the images and any associated generated or obtained information are stored for later use in block 480, and optionally provided to one or more recipients (*e*.*g*., to block 512 of routine 500 if invoked from that block). Figures 5A-5B illustrate one example of a routine for generating a floor plan representation of a building interior from the generated panorama information.

If it is instead determined in block 410 that the instructions or other information received in block 405 are not to acquire images and other data representing a building interior, the routine continues instead to block 490 to perform any other indicated operations as appropriate, such as to configure parameters to be used in various operations of the system (*e*.*g*., based at least in part on information specified by a user of the system, such as a user of a mobile device who captures one or more building interiors, an operator user of the ICA system, etc.), to respond to requests for generated and stored information (*e*.*g*., to identify one or more groups of inter-connected linked panorama images each representing a building or part of a building that match one or more specified search criteria, one or more panorama images that match one or more specified search criteria, etc.), to generate and store inter-panorama image connections between panorama images for a building or other structure (*e*.*g*., for each panorama image, to determine directions within that panorama image toward one or more other acquisition locations of one or more other panorama images, such as to enable later display of an arrow or other visual representation with a panorama image for each such determined direction from the panorama image to enable an end-user to select one of the displayed visual representations to switch to a display of the other panorama image at the other acquisition location to which the selected visual representation corresponds), to obtain and store other information about users of the system, to perform any housekeeping tasks, etc.

Following blocks 480 or 490, the routine proceeds to block 495 to determine whether to continue, such as until an explicit indication to terminate is received, or instead only if an explicit indication to continue is received. If it is determined to continue, the routine returns to block 405 to await additional instructions or information, and if not proceeds to step 499 and ends.

Figures 5A-5B illustrate an example embodiment of a flow diagram for a MIGM (Mapping Information Generation Manager) system routine 500. The routine may be performed by, for example, execution of the MIGM system 160 of Figure 1, the MIGM system 389 of Figure 3, and/or a MIGM system as described with respect to Figures 2A-2H and elsewhere herein, such as to determine a room shape for a room (or other defined area) by analyzing information from one or more images acquired in the room (*e*.*g*., one or more 360° panorama images), to generate a partial or complete floor plan for a building or other defined area based at least in part on one or more images of the area and optionally additional data captured by a mobile computing device, and/or to generate other mapping information for a building or other defined area based at least in part on one or more images of the area and optionally additional data captured by a mobile computing device. In the example of Figures 5A-5B, the determined room shape for a room may be a 2D room shape to represent the locations of the walls of the room or a 3D fully closed combination of planar surfaces to represent the locations of walls and ceiling and floor of the room, and the generated mapping information for a building (*e*.*g*., a house) may include a 2D floor plan and/or 3D computer model floor plan, but in other embodiments, other types of room shapes and/or mapping information may be generated and used in other manners, including for other types of structures and defined areas, as discussed elsewhere herein.

The illustrated embodiment of the routine begins at block 505, where information or instructions are received. The routine continues to block 510 to determine whether image information is already available to be analyzed for one or more rooms (*e*.*g*., for some or all of an indicated building, such as based on one or more such images received in block 505 as previously generated by the ICA routine), or if such image information instead is to be currently acquired. If it is determined in block 510 to currently acquire some or all of the image information, the routine continues to block 512 to acquire such information, optionally waiting for one or more users or devices to move throughout one or more rooms of a building and acquire panoramas or other images at one or more acquisition locations in one or more of the rooms (*e*.*g*., at multiple acquisition locations in each room of the building), optionally along with metadata information regarding the acquisition and/or interconnection information related to movement between acquisition locations, as discussed in greater detail elsewhere herein - implementation of block 512 may, for example, include invoking an ICA system routine to perform such activities, with Figure 4 providing one example embodiment of an ICA system routine for performing such image acquisition. If it is instead determined in block 510 not to currently acquire the images, the routine continues instead to block 515 to obtain one or more existing panoramas or other images from one or more acquisition locations in one or more rooms (*e*.*g*., multiple images acquired at multiple acquisition locations that include at least one image and acquisition location in each room of a building), optionally along with metadata information regarding the acquisition and/or interconnection information related to movement between the acquisition locations, such as may in some situations have been supplied in block 505 along with the corresponding instructions.

After blocks 512 or 515, the routine continues to block 520, where it determines whether to generate mapping information that includes a linked set of target panorama images (or other images) for a building or other group of rooms (referred to at times as a 'virtual tour', such as to enable an end user to move from any one of the images of the linked set to one or more other images to which that starting current image is linked, including in some embodiments via selection of a user-selectable control for each such other linked image that is displayed along with a current image, optionally by overlaying visual representations of such user-selectable controls and corresponding inter-image directions on the visual data of the current image, and to similarly move from that next image to one or more additional images to which that next image is linked, etc.), and if so continues to block 525. The routine in block 525 selects pairs of at least some of the images (*e*.*g*., based on the images of a pair having overlapping visual content), and determines, for each pair, relative directions between the images of the pair based on shared visual content and/or on other captured linking interconnection information (*e*.*g*., movement information) related to the images of the pair (whether movement directly from the acquisition location for one image of a pair to the acquisition location of another image of the pair, or instead movement between those starting and ending acquisition locations via one or more other intermediary acquisition locations of other images). The routine in block 525 may further optionally use at least the relative direction information for the pairs of images to determine global relative positions of some or all of the images to each other in a common coordinate system, and/or generate the inter-image links and corresponding user-selectable controls as noted above. Additional details are included elsewhere herein regarding creating such a linked set of images.

After block 525, or if it is instead determined in block 520 that the instructions or other information received in block 505 are not to determine a linked set of images, the routine continues to block 535 to determine whether the instructions received in block 505 indicate to generate other mapping information for an indicated building (*e*.*g*., a floor plan), and if so the routine continues to perform some or all of blocks 537-585 to do so, and otherwise continues to block 590. In block 537, the routine optionally obtains additional information about the building, such as from activities performed during acquisition and optionally analysis of the images, and/or from one or more external sources (*e*.*g*., online databases, information provided by one or more end users, etc.) - such additional information may include, for example, exterior dimensions and/or shape of the building, additional images and/or annotation information acquired corresponding to particular locations external to the building (*e*.*g*., surrounding the building and/or for other structures on the same property, from one or more overhead locations, etc.), additional images and/or annotation information acquired corresponding to particular locations within the building (optionally for locations different from acquisition locations of the acquired panorama images or other images), etc.

After block 537, the routine continues to block 540 to select the next room (beginning with the first) for which one or more images (*e*.*g*., 360° panorama images) acquired in the room are available, and to analyze the visual data of the image(s) for the room to determine a room shape (*e*.*g*., by determining at least wall locations), optionally along with determining uncertainty information about walls and/or other parts of the room shape, and optionally including identifying other wall and floor and ceiling elements (*e*.*g*., wall structural elements/features, such as windows, doorways and stairways and other inter-room wall openings and connecting passages, wall borders between a wall and another wall and/or ceiling and/or floor, etc.) and their positions within the determined room shape of the room. In some embodiments, the room shape determination may include using boundaries of the walls with each other and at least one of the floor or ceiling to determine a 2D room shape (*e*.*g*., using one or trained machine learning models), while in other embodiments the room shape determination may be performed in other manners (*e*.*g*., by generating a 3D point cloud of some or all of the room walls and optionally the ceiling and/or floor, such as by analyzing at least visual data of the panorama image and optionally additional data captured by an image acquisition device or associated mobile computing device, optionally using one or more of SfM (Structure from Motion) or SLAM (Simultaneous Location And Mapping) or MVS (Multi-View Stereo) analysis). In addition, the activities of block 545 may further optionally determine and use initial pose information for each of those panorama images (*e*.*g*., as supplied with acquisition metadata for the panorama image), and/or obtain and use additional metadata for each panorama image (*e*.*g*., acquisition height information of the camera device or other image acquisition device used to acquire a panorama image relative to the floor and/or the ceiling). Additional details are included elsewhere herein regarding determining room shapes and identifying additional information for the rooms. After block 540, the routine continues to block 545, where it determines whether there are more rooms for which to determine room shapes based on images acquired in those rooms, and if so returns to block 540 to select the next such room for which to determine a room shape.

If it is instead determined in block 545 that there are not more rooms for which to generate room shapes, the routine continues to block 560 to determine whether to further generate at least a partial floor plan for the building (*e*.*g*., based at least in part on the determined room shape(s) from block 540, and optionally further information regarding how to position the determined room shapes relative to each other). If not, such as when determining only one or more room shapes without generating further mapping information for a building (*e*.*g*., to determine the room shape for a single room based on one or more images acquired in the room by the ICA system), the routine continues to block 588. Otherwise, the routine continues to block 565 to retrieve one or more room shapes (*e*.*g*., room shapes generated in block 545) or otherwise obtain one or more room shapes (*e*.*g*., based on human-supplied input) for rooms of the building, whether 2D or 3D room shapes, and then continues to block 570. In block 570, the routine uses the one or more room shapes to create an initial floor plan (*e*.*g*., an initial 2D floor plan using 2D room shapes and/or an initial 3D floor plan using 3D room shapes), such as a partial floor plan that includes one or more room shapes but less than all room shapes for the building, or a complete floor plan that includes all room shapes for the building. If there are multiple room shapes, the routine in block 570 further determines positioning of the room shapes relative to each other, such as by using visual overlap between images from multiple acquisition locations to determine relative positions of those acquisition locations and of the room shapes surrounding those acquisition locations, and/or by using other types of information (*e*.*g*., using connecting inter-room passages between rooms, optionally applying one or more constraints or optimizations, etc.). In at least some embodiments, the routine in block 570 further refines some or all of the room shapes by generating a binary segmentation mask that covers the relatively positioned room shape(s), extracting a polygon representing the outline or contour of the segmentation mask, and separating the polygon into the refined room shape(s). Such a floor plan may include, for example, relative position and shape information for the various rooms without providing any actual dimension information for the individual rooms or building as a whole, and may further include multiple linked or associated sub-maps (*e*.*g*., to reflect different stories, levels, sections, etc.) of the building. The routine further optionally associates positions of the doors, wall openings and other identified wall elements on the floor plan.

After block 570, the routine optionally performs one or more steps 580-585 to determine and associate additional information with the floor plan. In block 580, the routine optionally estimates the dimensions of some or all of the rooms, such as from analysis of images and/or their acquisition metadata or from overall dimension information obtained for the exterior of the building, and associates the estimated dimensions with the floor plan - it will be appreciated that if sufficiently detailed dimension information were available, architectural drawings, blueprints, etc. may be generated from the floor plan. After block 580, the routine continues to block 583 to optionally associate further information with the floor plan (*e*.*g*., with particular rooms or other locations within the building), such as additional existing images with specified positions and/or annotation information. In block 585, if the room shapes from block 545 are not 3D room shapes, the routine further optionally estimates heights of walls in some or all rooms, such as from analysis of images and optionally sizes of known objects in the images, as well as height information about a camera when the images were acquired, and uses that height information to generate 3D room shapes for the rooms. The routine further optionally uses the 3D room shapes (whether from block 540 or block 585) to generate a 3D computer model floor plan of the building, with the 2D and 3D floor plans being associated with each other - in other embodiments, only a 3D computer model floor plan may be generated and used (including to provide a visual representation of a 2D floor plan if so desired by using a horizontal slice of the 3D computer model floor plan).

After block 585, or if it is instead determined in block 560 not to determine a floor plan, the routine continues to block 588 to store the determined room shape(s) and/or generated mapping information and/or other generated information, to optionally provide some or all of that information to one or more recipients (*e*.*g*., to block 440 of routine 400 if invoked from that block), and to optionally further use some or all of the determined and generated information, such as to provide the generated 2D floor plan and/or 3D computer model floor plan for display on one or more client devices and/or to one or more other devices for use in automating navigation of those devices and/or associated vehicles or other entities, to similarly provide and use information about determined room shapes and/or a linked set of panorama images and/or about additional information determined about contents of rooms and/or passages between rooms, etc.

If it is instead determined in block 535 that the information or instructions received in block 505 are not to generate mapping information for an indicated building, the routine continues instead to block 590 to perform one or more other indicated operations as appropriate. Such other operations may include, for example, receiving and responding to requests for previously generated floor plans and/or previously determined room shapes and/or other generated information (*e*.*g*., requests for such information for display on one or more client devices, requests for such information to provide it to one or more other devices for use in automated navigation, etc.), obtaining and storing information about buildings for use in later operations (*e*.*g*., information about dimensions, numbers or types of rooms, total square footage, adjacent or nearby other buildings, adjacent or nearby vegetation, exterior images, etc.), etc.

After blocks 588 or 590, the routine continues to block 595 to determine whether to continue, such as until an explicit indication to terminate is received, or instead only if an explicit indication to continue is received. If it is determined to continue, the routine returns to block 505 to wait for and receive additional instructions or information, and otherwise continues to block 599 and ends.

While not illustrated with respect to the automated operations shown in the example embodiment of Figures 5A-5B, in some embodiments human users may further assist in facilitating some of the operations of the MIGM system, such as for operator users and/or end users of the MIGM system to provide input of one or more types that is further used in subsequent automated operations. As non-exclusive examples, such human users may provide input of one or more types as follows: to provide input to assist with the linking of a set of images, such as to provide input in block 525 that is used as part of the automated operations for that block (*e*.*g*., to specify or adjust initial automatically determined directions between one or more pairs of images, to specify or adjust initial automatically determined final global positions of some or all of the images relative to each other, etc.); to provide input in block 537 that is used as part of subsequent automated operations, such as one or more of the illustrated types of information about the building; to provide input with respect to block 540 that is used as part of subsequent automated operations, such as to specify or adjust initial automatically determined element locations and/or estimated room shapes and/or to manually combine information from multiple estimated room shapes for a room (*e*.*g*., separate room shape estimates from different images acquired in the room) to create a final room shape for the room and/or to specify or adjust initial automatically determined information about a final room shape, etc.; to provide input with respect to block 570, that is used as part of subsequent operations, such as to specify or adjust initial automatically determined positions of room shapes within a floor plan being generated and/or to specify or adjust initial automatically determined room shapes themselves within such a floor plan; to provide input with respect to one or more of blocks 580 and 583 and 585 that is used as part of subsequent operations, such as to specify or adjust initial automatically determined information of one or more types discussed with respect to those blocks; and/or to specify or adjust initial automatically determined pose information (whether initial pose information or subsequent updated pose information) for one or more of the panorama images; etc. Additional details are included elsewhere herein regarding embodiments in which one or more human users provide input that is further used in additional automated operations of the BOBSDM system.

Figure 6 illustrates an example embodiment of a flow diagram for a Building Object-Based Scale Determination Manager (BOBSDM) System routine 600. The routine may be performed by, for example, execution of the BOBSDM system 140 of Figure 1, the BOBSDM system 340 of Figure 3, and/or an BOBSDM system as described with respect to Figures 2I-2L and elsewhere herein, such as to perform automated operations related to analyzing visual data of images acquired at a building to determine building information that includes building dimensions. In the example embodiment of Figure 6, the images are for houses or other buildings, but in other embodiments, similar analyses may be performed for other types of structures or for non-structure locations, and the results may be used in other manners than those discussed with respect to routine 600, as discussed elsewhere herein.

The illustrated embodiment of the routine begins at block 605, where one or more images for a building are received (*e*.*g*., multiple images captured throughout multiple rooms of a building). The routine continues to block 610 to analyze each image to identify any visible objects of one or more defined types (*e*.*g*., to identify the four corners of doorways; to identify at least the bottom and top of floor cabinets, such as for each pixel column having visual data showing such a cabinet, etc.). In block 615, the routine then, for each identified physical object, transforms points in the image corresponding to the object from a local relative coordinate system for the image to an actual physical coordinate system, including to determine the estimated camera height during the image acquisition using assumed physical dimensions (*e*.*g*., height) of that object's defined type, and to use that estimated camera height to determine actual distances corresponding to the transformed points. In block 620, the routine then, if more than one physical object was identified in the one or more images, compares some or all of the determined estimated camera heights (*e*.*g*., all heights for all objects of multiple object types across multiple images, multiple heights for different objects of the same type in one or more images, multiple heights for objects of different types in the same image, etc.), and determines if they satisfy one or more defined validation criteria. In some embodiments and situations, an intermediate aggregated estimated camera height may first be determined for each object type, such as by combining estimated camera heights for multiple objects of that type in one or more images, with multiple such intermediate aggregated estimated camera heights then compared to determine if they satisfy the one or more defined validation criteria.

In block 625, the routine then determines if the validation criteria are satisfied (or if no validation criteria are used, such if a single estimated camera height was determined in block 615), and if so proceeds to perform blocks 630-640, and otherwise proceeds to block 650. In block 630, the routine uses the compared estimated camera heights to determine the final estimated camera height for the one or more images (*e*.*g*., by determining a mean or other average of them; by selecting a single estimated camera height, such as a minimum or maximum; etc.), and in block 635 proceeds to determine building dimensions for portions of the building visible in those images based on the final estimated camera height (*e*.*g*., lengths/widths and/or heights of walls, dimensions of other visible objects and/or elements, overall room sizes, overall building dimensions if the images cover all of the building, etc.). In block 640, the routine then optionally further validates the determined camera height and resulting building dimensions using an alternative manner, such as by using a generated floorplan from the images (optionally waiting until it is generated if not yet done) and fitting an exterior of the floorplan to a visible exterior of the building in an overhead image, and using size information associated with the overhead image (*e*.*g*., GPS data) to determine the resulting overall building dimensions, from which the dimensions of particular rooms may be determined and matched to corresponding room dimensions determined from using the final estimated camera height - if such a comparison is performed and the building and/or room dimensions from the two techniques are not a match (*e*.*g*., differ by more than a defined threshold amount), final building dimension information to use may be determined in one or more manners, such as to select the results from one of the two techniques (*e*.*g*., a predefined preferred one of the two), to average or otherwise combine the dimensions from the two techniques, to request a separate review and determination (*e*.*g*., by a human operator user), etc. If it is instead determined in block 625 that the validation criteria are not satisfied, the routine continues to block 650 to perform a similar technique to that discussed with respect to block 640 to be used instead of information based on the estimated camera heights.

After blocks 640 or 650, the routine continues to block 695 to determine whether to continue, such as until an explicit indication to terminate is received, or instead only if an explicit indication to continue is received. If it is determined to continue, the routine returns to block 605 to wait for and receive additional images to analyze, and otherwise continues to block 699 and ends.

Figure 7 illustrates an example embodiment of a flow diagram for a Building Information Access system routine 700. The routine may be performed by, for example, execution of a building information access client computing device 175 and its software system(s) (not shown) of Figure 1, a client computing device 390 of Figure 3, and/or a building information access viewer or presentation system as described elsewhere herein, such as to receive and display generated floor plans and/or other mapping information (*e*.*g*., determined room structural layouts/shapes, etc.) for a defined area that optionally include visual indications of one or more determined image acquisition locations, to obtain and display information about images matching one or more indicated target images, to display additional information (*e*.*g*., images) associated with particular acquisition locations in the mapping information, to obtain and display guidance acquisition instructions provided by the BOBSDM system and/or other sources (*e*.*g*., with respect to other images acquired during that acquisition session and/or for an associated building, such as part of a displayed GUI), to obtain and display explanations or other descriptions of matching between two or more buildings or properties, etc. In the example of Figure 7, the presented mapping information is for a building (such as an interior of a house), but in other embodiments, other types of mapping information may be presented for other types of buildings or environments and used in other manners, as discussed elsewhere herein.

The illustrated embodiment of the routine begins at block 705, where instructions or information are received. At block 710, the routine determines whether the received instructions or information in block 705 are to display determined information for one or more target buildings, and if so continues to block 715 to determine whether the received instructions or information in block 705 are to select one or more target buildings using specified criteria (*e*.*g*., based at least in part on an indicated building), and if not continues to block 725 to obtain an indication of a target building to use from the user (*e*.*g*., based on a current user selection, such as from a displayed list or other user selection mechanism; based on information received in block 705; etc.). Otherwise, if it is determined in block 715 to select one or more target buildings from specified criteria (*e*.*g*., based at least in part on an indicated building), the routine continues instead to block 720, where it obtains indications of one or more search criteria to use, such as from current user selections or as indicated in the information or instructions received in block 705, and then searches stored information about buildings to determine one or more of the buildings that satisfy the search criteria or otherwise obtains indications of one or more such matching buildings, such as based at least in part on building dimensions information generated by the BOBSDM system. In the illustrated embodiment, the routine then further selects a best match target building from the one or more returned buildings (*e*.*g*., the returned other building with the highest similarity or other matching rating for the specified criteria, or using another selection technique indicated in the instructions or other information received in block 705), while in other embodiments the routine may instead present multiple candidate buildings that satisfy the search criteria (*e*.*g*., in a ranked order based on degree of match) and receive a user selection of the target building from the multiple candidates.

After blocks 720 or 725, the routine continues to block 735 to retrieve a floor plan for the target building and/or other generated mapping information for the building (*e*.*g*., a group of inter-linked images for use as part of a virtual tour), and optionally indications of associated linked information for the building interior and/or a surrounding location external to the building, and/or information about one or more generated explanations or other descriptions of why the target building is selected as matching specified criteria (*e*.*g*., based in part or in whole on one or more other indicated buildings), and selects an initial view of the retrieved information (*e*.*g*., a view of the floor plan, a particular room shape, a particular image, etc., optionally along with generated explanations or other descriptions of why the target building is selected to be matching if such information is available). In block 740, the routine then displays or otherwise presents the current view of the retrieved information, and waits in block 745 for a user selection. After a user selection in block 745, if it is determined in block 750 that the user selection corresponds to adjusting the current view for the current target building (*e*.*g*., to change one or more aspects of the current view), the routine continues to block 755 to update the current view in accordance with the user selection, and then returns to block 740 to update the displayed or otherwise presented information accordingly. The user selection and corresponding updating of the current view may include, for example, displaying or otherwise presenting a piece of associated linked information that the user selects (*e*.*g*., a particular image associated with a displayed visual indication of a determined acquisition location, such as to overlay the associated linked information over at least some of the previous display; a particular other image linked to a current image and selected from the current image using a user-selectable control overlaid on the current image to represent that other image; etc.), and/or changing how the current view is displayed (*e*.*g*., zooming in or out; rotating information if appropriate; selecting a new portion of the floor plan to be displayed or otherwise presented, such as with some or all of the new portion not being previously visible, or instead with the new portion being a subset of the previously visible information; etc.). If it is instead determined in block 750 that the user selection is not to display further information for the current target building (*e*.*g*., to display information for another building, to end the current display operations, etc.), the routine continues instead to block 795, and returns to block 705 to perform operations for the user selection if the user selection involves such further operations.

If it is instead determined in block 710 that the instructions or other information received in block 705 are not to present information representing a building, the routine continues instead to block 760 to determine whether the instructions or other information received in block 705 correspond to identifying other images (if any) corresponding to one or more indicated target images, and if so continues to blocks 765-770 to perform such activities. In particular, the routine in block 765 receives the indications of the one or more target images for the matching (such as from information received in block 705 or based on one or more current interactions with a user) along with one or more matching criteria (*e*.*g*., an amount of visual overlap), and in block 770 identifies one or more other images (if any) that match the indicated target image(s), such as by interacting with the ICA and/or MIGM systems to obtain the other image(s). The routine then displays or otherwise provides information in block 770 about the identified other image(s), such as to provide information about them as part of search results, to display one or more of the identified other image(s), etc. If it is instead determined in block 760 that the instructions or other information received in block 705 are not to identify other images corresponding to one or more indicated target images, the routine continues instead to block 775 to determine whether the instructions or other information received in block 705 correspond to obtaining and providing guidance acquisition instructions during an image acquisition session with respect to one or more indicated target images (*e*.*g*., a most recently acquired image), and if so continues to block 780, and otherwise continues to block 790. In block 780, the routine obtains information about guidance acquisition instructions of one or more types, such as by interacting with the ICA system, and displays or otherwise provides information in block 780 about the guidance acquisition instructions, such as by overlaying the guidance acquisition instructions on a partial floor plan and/or recently acquired image in manners discussed in greater detail elsewhere herein.

In block 790, the routine continues instead to perform other indicated operations as appropriate, such as to configure parameters to be used in various operations of the system (*e*.*g*., based at least in part on information specified by a user of the system, such as a user of a mobile device who acquires one or more building interiors, an operator user of the BOBSDM and/or MIGM systems, etc., including for use in personalizing information display for a particular user in accordance with his/her preferences), to obtain and store other information about users of the system, to respond to requests for generated and stored information, to perform any housekeeping tasks, etc.

Following blocks 770 or 780 or 790, or if it is determined in block 750 that the user selection does not correspond to the current building, the routine proceeds to block 795 to determine whether to continue, such as until an explicit indication to terminate is received, or instead only if an explicit indication to continue is received. If it is determined to continue (including if the user made a selection in block 745 related to a new building to present), the routine returns to block 705 to await additional instructions or information (or to continue directly on to block 735 if the user made a selection in block 745 related to a new building to present), and if not proceeds to step 799 and ends.

Aspects of the present disclosure are described herein with reference to flowchart illustrations and/or block diagrams of methods, apparatus (systems), and computer program products according to embodiments of the present disclosure. It will be appreciated that each block of the flowchart illustrations and/or block diagrams, and combinations of blocks in the flowchart illustrations and/or block diagrams, can be implemented by computer readable program instructions. It will be further appreciated that in some implementations the functionality provided by the routines discussed above may be provided in alternative ways, such as being split among more routines or consolidated into fewer routines. Similarly, in some implementations illustrated routines may provide more or less functionality than is described, such as when other illustrated routines instead lack or include such functionality respectively, or when the amount of functionality that is provided is altered. In addition, while various operations may be illustrated as being performed in a particular manner (*e*.*g*., in serial or in parallel, or synchronous or asynchronous) and/or in a particular order, in other implementations the operations may be performed in other orders and in other manners. Any data structures discussed above may also be structured in different manners, such as by having a single data structure split into multiple data structures and/or by having multiple data structures consolidated into a single data structure. Similarly, in some implementations illustrated data structures may store more or less information than is described, such as when other illustrated data structures instead lack or include such information respectively, or when the amount or types of information that is stored is altered.

## Claims

1. A computer-implemented method comprising:
obtaining (605), by one or more computing devices, a plurality of images captured in multiple rooms of a building by a camera device positioned at an actual camera height above floors of the multiple rooms during capturing of the plurality of images;
analyzing (610), by the one or more computing devices, visual data of the plurality of images to identify multiple doorways and multiple cabinets visible in multiple images of the plurality of images, the multiple cabinets each being installed on a floor of one of the multiple rooms;
determining (615), by the one or more computing devices and for each of the multiple doorways, a first estimate of the actual camera height for one or more images of the multiple images in which that doorway is visible by using a predefined first estimated height of the multiple doorways and information about positions in those one or more images of corners of that doorway, and generating an aggregated first estimated camera height of the camera device by combining determined first estimates of the actual camera height for the multiple doorways;
determining (615), by the one or more computing devices and for each of the multiple cabinets, a second estimate of the actual camera height for at least one image of the multiple images in which that cabinet is visible by using a predefined second estimated height of the multiple cabinets and information about positions in those at least one images of a top and a bottom of that cabinet, and generating an aggregated second estimated camera height of the camera device by combining determined second estimates of the actual camera height for the multiple cabinets;
verifying (620), by the one or more computing devices, that the aggregated first and second estimated camera heights of the camera device differ by at most a defined threshold amount;
determining (630), by the one or more computing devices and in response to the verifying, a final estimate of the actual camera height by combining the aggregated first and second estimated camera heights of the camera device;
determining (635), by the one or more computing devices and based on the determined final estimate of the actual camera height and the visual data of the plurality of images, dimensions of the multiple rooms by, for each of the multiple rooms and each of at least some walls of that room, assigning at least a length to that wall of that room using information about positions of corners of that wall of that room in the plurality of images; and
providing, by the one or more computing devices, the determined dimensions of the multiple rooms for use with a floor plan of the building.

2. The computer-implemented method of claim 1 further comprising generating the floor plan of the building based on the visual data of the plurality of images, the floor plan including at least two-dimensional room shapes and relative positions of the multiple rooms, and wherein the providing of the determined dimensions of the multiple rooms includes presenting a visual representation of the floor plan with overlaid information about dimensions of the building that are based on the determined dimensions of the multiple rooms.

3. The computer-implemented method of claim 1 further comprising:
fitting, by the one or more computing devices, exterior walls of a floor plan for the building to an exterior of the building visible in an overhead image of the building;
using, by the one or more computing devices, determined size information of the exterior of the building in the overhead image to determine dimensions of walls of the multiple rooms; and
determining, by the one or more computing devices, a third estimate of the actual camera height based at least in part on the determined dimensions of the walls of the multiple rooms and on portions of the visual data of the plurality of images that show the walls of the multiple rooms, including using information about, for each of the walls of the multiple rooms, information about positions of corners of that wall in the plurality of images,
and wherein the verifying further includes determining that the determined third estimate of the actual camera height differs from the aggregated first and second estimated camera heights by at most the defined threshold amount.

4. The computer-implemented method of claim 1 wherein each of the plurality of images is a straightened panorama image in equirectangular format, and wherein the analyzing of the visual data of the plurality of images to identify the multiple doorways and the multiple cabinets includes using one or more machine learning models trained to identify doorways and cabinets.

5. The computer-implemented method of claim 1 wherein the determining of at least one of the first estimate of the actual camera height or the second estimate of the actual camera height includes using one or more machine learning models trained to use visual data of at least one of doorways or cabinets installed on floors.

6. The computer-implemented method of claim 1 wherein the analyzing of the visual data of the plurality of images further includes identifying at least one additional object of at least one additional object type, the at least one additional object type being at least one of an oven, or a dishwasher, or an electrical plate, or an air outlet, or a fan blade, or a bed, or a television, or an electrical outlet, or a wall switch plate, wherein the method further comprises determining a third estimate of the actual camera height for each of the at least one additional object types using visual data of at least one identified additional object of that additional object type, including using information about, for each of the at least one identified additional objects of that additional object type, information about positions of corners of that identified additional object in the plurality of images, and wherein the determining of the final estimate of the actual camera height further includes combining the determined third estimate of the actual camera height for each of the at least one additional object types.

7. A system comprising:
one or more hardware processors of one or more computing devices; and
one or more memories with stored instructions that, when executed by at least one of the one or more hardware processors, cause at least one computing device of the one or more computing devices to perform automated operations including at least:
obtaining (605) a plurality of images captured in multiple rooms of a building by a camera device positioned at an actual camera height above floors of the multiple rooms during capturing of the plurality of images;
analyzing (610) visual data of the plurality of images to identify multiple doorways and multiple cabinets visible in multiple images of the plurality of images, the multiple cabinets each being installed on a floor of one of the multiple rooms;
determining (615), for each of the multiple doorways, a first estimate of the actual camera height for one or more images of the multiple images in which that doorway is visible by using a predefined first estimated height of the multiple doorways and information about positions in those one or more images of corners of that doorway, and generating an aggregated first estimated camera height of the camera device by combining determined first estimates of the actual camera height for the multiple doorways;
determining (615), for each of the multiple cabinets, a second estimate of the actual camera height for at least one image of the multiple images in which that cabinet is visible by using a predefined second estimated height of the multiple cabinets and information about positions in those at least one images of a top and a bottom of that cabinet, and generating an aggregated second estimated camera height of the camera device by combining determined second estimates of the actual camera height for the multiple cabinets;
verifying (620) that the aggregated first and second estimated camera heights of the camera device differ by at most a defined threshold amount;
determining (630), in response to the verifying, a final estimate of the actual camera height by combining the aggregated first and second estimated camera heights of the camera device;
determining (635), based on the determined final estimate of the actual camera height and the visual data of the plurality of images, dimensions of the multiple rooms by, for each of the multiple rooms and each of at least some walls of that room, assigning at least a length to that wall of that room using information about positions of corners of that wall of that room in the plurality of images; and
providing the determined dimensions of the multiple rooms for use with a floor plan of the building.

8. The system of claim 7 wherein the automated operations further include generating the floor plan of the building based on the visual data of the plurality of images, the floor plan including at least two-dimensional room shapes and relative positions of the multiple rooms, and wherein the providing of the determined dimensions of the multiple rooms includes presenting a visual representation of the floor plan with overlaid information about dimensions of the building that are based on the determined dimensions of the multiple rooms.

9. The system of claim 7 wherein the automated operations further include:
fitting exterior walls of a floor plan for the building to an exterior of the building visible in an overhead image of the building;
using determined size information of the exterior of the building in the overhead image to determine dimensions of walls of the multiple rooms; and
determining a third estimate of the actual camera height based at least in part on the determined dimensions of the walls of the multiple rooms and on portions of the visual data of the plurality of images that show the walls of the multiple rooms, including using information about, for each of the walls of the multiple rooms, information about positions of corners of that wall in the plurality of images,
and wherein the verifying further includes determining that the determined third estimate of the actual camera height differs from the aggregated first and second estimated camera heights by at most the defined threshold amount.

10. The system of claim 7 wherein each of the plurality of images is a straightened panorama image in equirectangular format, and wherein the analyzing of the visual data of the plurality of images to identify the multiple doorways and the multiple cabinets includes using one or more machine learning models trained to identify doorways and cabinets.

11. The system of claim 7 wherein the determining of at least one of the first estimate of the actual camera height or the second estimate of the actual camera height includes using one or more machine learning models trained to use visual data of at least one of doorways or cabinets installed on floors.

12. The system of claim 7 wherein the analyzing of the visual data of the plurality of images further includes identifying at least one additional object of at least one additional object type, the at least one additional object type being at least one of an oven, or a dishwasher, or an electrical plate, or an air outlet, or a fan blade, or a bed, or a television, or an electrical outlet, or a wall switch plate, wherein the automated operations further include determining a third estimate of the actual camera height for each of the at least one additional object types using visual data of at least one identified additional object of that additional object type, including using information about, for each of the at least one identified additional objects of that additional object type, information about positions of corners of that identified additional object in the plurality of images, and wherein the determining of the final estimate of the actual camera height further includes combining the determined third estimate of the actual camera height for each of the at least one additional object types.

13. A non-transitory computer-readable medium having stored contents that cause one or more computing devices to perform automated operations to implement the method of any one of claims 1 to 6.

## Patentansprüche

1. Computerimplementiertes Verfahren, umfassend:
Erhalten (605), durch eine oder mehrere Rechenvorrichtungen, einer Mehrzahl von Bildern, die in mehreren Räumen eines Gebäudes durch eine Kameravorrichtung erfasst werden, die während des Erfassens der Mehrzahl von Bildern auf einer tatsächlichen Kamerahöhe über Fußböden der mehreren Räume positioniert ist;
Analysieren (610), durch die eine oder mehreren Rechenvorrichtungen, von visuellen Daten der Mehrzahl von Bildern zum Ermitteln mehrerer Türdurchgänge und mehrerer Schränke, die in mehreren Bildern der Mehrzahl von Bildern sichtbar sind, wobei die mehreren Schränke jeweils auf einem Fußboden von einem der mehreren Räume aufgestellt sind;
Bestimmen (615), durch die eine oder mehreren Rechenvorrichtungen und für jeden der mehreren Türdurchgänge, einer ersten Schätzung der tatsächlichen Kamerahöhe für ein oder mehrere Bilder der mehreren Bilder, in denen dieser Türdurchgang sichtbar ist, mittels einer vordefinierten ersten geschätzten Höhe der mehreren Türdurchgänge und Informationen über Positionen in diesem einen bzw. diesen mehreren Bildern von Ecken dieses Türdurchgangs und Erzeugen einer zusammengesetzten ersten geschätzten Kamerahöhe der Kameravorrichtung durch Kombinieren bestimmter erster Schätzungen der tatsächlichen Kamerahöhe für die mehreren Türdurchgänge;
Bestimmen (615), durch die eine oder mehreren Rechenvorrichtungen und für jeden der mehreren Schränke, einer zweiten Schätzung der tatsächlichen Kamerahöhe für mindestens ein Bild der mehreren Bilder, in dem dieser Schrank sichtbar ist, mittels einer vordefinierten zweiten geschätzten Höhe der mehreren Schränke und Informationen über Positionen in diesem mindestens einen Bild von einem oberen und einem unteren Ende dieses Schranks und Erzeugen einer zusammengesetzten zweiten geschätzten Kamerahöhe der Kameravorrichtung durch Kombinieren bestimmter zweiter Schätzungen der tatsächlichen Kamerahöhe für die mehreren Schränke;
Überprüfen (620), durch die eine oder mehreren Rechenvorrichtungen, dass die zusammengesetzte erste und zweite geschätzte Kamerahöhe der Kameravorrichtung sich durch höchstens einen definierten Schwellenwert unterscheiden;
Bestimmen (630), durch die eine oder mehreren Rechenvorrichtungen und als Reaktion auf das Überprüfen, einer endgültigen Schätzung der tatsächlichen Kamerahöhe durch Kombinieren der zusammengesetzten ersten und zweiten geschätzten Kamerahöhe der Kameravorrichtung;
Bestimmen (635), durch die eine oder mehreren Rechenvorrichtungen und auf Basis der bestimmten endgültigen Schätzung der tatsächlichen Kamerahöhe und der visuellen Daten der Mehrzahl von Bildern, von Dimensionen der mehreren Räume durch, für jeden der mehreren Räume und jede der mindestens einigen Wände dieses Raums, Zuweisen mindestens einer Länge dieser Wand dieses Raums unter Verwendung von Informationen über Positionen von Ecken dieser Wand dieses Raums in der Mehrzahl von Bildern; und
Bereitstellen, durch die eine oder mehreren Rechenvorrichtungen, der bestimmten Dimensionen der mehreren Räume zur Verwendung mit einem Raumplan des Gebäudes.

2. Computerimplementiertes Verfahren nach Anspruch 1, das ferner das Erzeugen des Raumplans des Gebäudes auf Basis der visuellen Daten der Mehrzahl von Bildern umfasst, wobei der Raumplan mindestens zweidimensionale Raumformen und relative Positionen der mehreren Räume aufweist, und wobei das Bereitstellen der bestimmten Dimensionen der mehreren Räume das Präsentieren einer visuellen Darstellung des Raumplans mit eingeblendeten Informationen über Dimensionen des Gebäudes aufweist, die auf den bestimmten Dimensionen der mehreren Räume basieren.

3. Computerimplementiertes Verfahren nach Anspruch 1, das ferner Folgendes umfasst:
Einsetzen, durch die eine oder mehreren Rechenvorrichtungen, von Außenwänden eines Raumplans für das Gebäude an einem Äußeren des Gebäudes, die in einer Draufsicht des Gebäudes sichtbar sind;
Verwenden, durch die eine oder mehreren Rechenvorrichtungen, von bestimmten Größeninformationen des Äußeren des Gebäudes in der Draufsicht zum Bestimmen von Dimensionen von Wänden der mehreren Räume; und
Bestimmen, durch die eine oder mehreren Rechenvorrichtungen, einer dritten Schätzung der tatsächlichen Kamerahöhe zumindest teilweise auf Basis der bestimmten Dimensionen der Wände der mehreren Räume und von Teilen der visuellen Daten der Mehrzahl von Bildern, die die Wände der mehreren Räume zeigen, einschließlich Verwenden von Informationen über, für jede der Wände der mehreren Räume, Informationen über Positionen von Ecken dieser Wand in der Mehrzahl von Bildern,
und wobei das Überprüfen ferner das Bestimmen aufweist, dass die bestimmte dritte Schätzung der tatsächlichen Kamerahöhe sich von der zusammengesetzten ersten und zweiten geschätzten Kamerahöhe um höchsten den definierten Schwellenwert unterscheidet.

4. Computerimplementiertes Verfahren nach Anspruch 1, wobei jedes der Mehrzahl von Bildern ein begradigtes Panoramabild in äquirektangulärem Format ist und wobei das Analysieren der visuellen Daten der Mehrzahl von Bildern zum Ermitteln der mehreren Türdurchgänge und der mehreren Schränke das Verwenden von einem oder mehreren Modellen des maschinellen Lernens aufweist, die zum Ermitteln von Türdurchgängen und Schränken trainiert sind.

5. Computerimplementiertes Verfahren nach Anspruch 1, wobei das Bestimmen von mindestens einem von der ersten Schätzung der tatsächlichen Kamerahöhe oder der zweiten Schätzung der tatsächlichen Kamerahöhe das Verwenden von einem oder mehreren Modellen des maschinellen Lernens aufweist, die zum Verwenden visueller Daten von mindestens einem von Türdurchgängen oder Schränken, die auf Fußböden aufgestellt sind, trainiert sind.

6. Computerimplementiertes Verfahren nach Anspruch 1, wobei das Analysieren der visuellen Daten der Mehrzahl von Bildern ferner das Ermitteln mindestens eines zusätzlichen Gegenstands mindestens einer zusätzlichen Gegenstandsart aufweist, wobei die mindestens eine zusätzliche Gegenstandsart mindestens eines von einem Ofen oder einem Geschirrspüler oder einer Herdplatte oder einem Luftaustritt oder einem Ventilatorflügel oder einem Bett oder einem Fernsehgerät oder einer Steckdose oder einer Wandschalterplatte ist, wobei das Verfahren ferner das Bestimmen einer dritten Schätzung der tatsächlichen Kamerahöhe für jede der mindestens einen zusätzlichen Gegenstandsart unter Verwendung visueller Daten von mindestens einem ermittelten zusätzlichen Gegenstand dieser zusätzlichen Gegenstandsart, einschließlich Verwenden von Informationen über, für jeden des mindestens einen ermittelten zusätzlichen Gegenstands dieser zusätzlichen Gegenstandsart, Informationen über Positionen von Ecken dieses ermittelten zusätzlichen Gegenstands in der Mehrzahl von Bildern, und wobei das Bestimmen der endgültigen Schätzung der tatsächlichen Kamerahöhe ferner das Kombinieren der bestimmten dritten Schätzung der tatsächlichen Kamerahöhe für jede der mindestens einen zusätzlichen Gegenstandsart aufweist.

7. System, umfassend:
einen oder mehrere Hardware-Prozessoren von einer oder mehreren Rechenvorrichtungen; und
einen oder mehrere Speicher mit gespeicherten Anweisungen, die bei Ausführung durch mindestens einen von dem einen oder den mehreren Hardware-Prozessoren mindestens eine Rechenvorrichtung der einen oder mehreren Rechenvorrichtungen zum Durchführen automatisierter Vorgänge veranlassen, die mindestens die folgenden beinhalten:
Erhalten (605) einer Mehrzahl von Bildern, die in mehreren Räumen eines Gebäudes durch eine Kameravorrichtung erfasst werden, die während des Erfassens der Mehrzahl von Bildern auf einer tatsächlichen Kamerahöhe über Fußböden der mehreren Räume positioniert ist;
Analysieren (610) von visuellen Daten der Mehrzahl von Bildern zum Ermitteln mehrerer Türdurchgänge und mehrerer Schränke, die in mehreren Bildern der Mehrzahl von Bildern sichtbar sind, wobei die mehreren Schränke jeweils auf einem Fußboden von einem der mehreren Räume aufgestellt sind;
Bestimmen (615), für jeden der mehreren Türdurchgänge, einer ersten Schätzung der tatsächlichen Kamerahöhe für ein oder mehrere Bilder der mehreren Bilder, in denen dieser Türdurchgang sichtbar ist, mittels einer vordefinierten ersten geschätzten Höhe der mehreren Türdurchgänge und Informationen über Positionen in diesem einen bzw. diesen mehreren Bildern von Ecken dieses Türdurchgangs und Erzeugen einer zusammengesetzten ersten geschätzten Kamerahöhe der Kameravorrichtung durch Kombinieren bestimmter erster Schätzungen der tatsächlichen Kamerahöhe für die mehreren Türdurchgänge;
Bestimmen (615), für jeden der mehreren Schränke, einer zweiten Schätzung der tatsächlichen Kamerahöhe für mindestens ein Bild der mehreren Bilder, in dem dieser Schrank sichtbar ist, mittels einer vordefinierten zweiten geschätzten Höhe der mehreren Schränke und Informationen über Positionen in diesem mindestens einen Bild von einem oberen und einem unteren Ende dieses Schranks und Erzeugen einer zusammengesetzten zweiten geschätzten Kamerahöhe der Kameravorrichtung durch Kombinieren bestimmter zweiter Schätzungen der tatsächlichen Kamerahöhe für die mehreren Schränke;
Überprüfen (620), dass die zusammengesetzte erste und zweite geschätzte Kamerahöhe der Kameravorrichtung sich durch höchstens einen definierten Schwellenwert unterscheiden;
Bestimmen (630), als Reaktion auf das Überprüfen, einer endgültigen Schätzung der tatsächlichen Kamerahöhe durch Kombinieren der zusammengesetzten ersten und zweiten geschätzten Kamerahöhe der Kameravorrichtung;
Bestimmen (635), auf Basis der bestimmten endgültigen Schätzung der tatsächlichen Kamerahöhe und der visuellen Daten der Mehrzahl von Bildern, von Dimensionen der mehreren Räume durch, für jeden der mehreren Räume und jede der mindestens einigen Wände dieses Raums, Zuweisen mindestens einer Länge dieser Wand dieses Raums unter Verwendung von Informationen über Positionen von Ecken dieser Wand dieses Raums in der Mehrzahl von Bildern; und
Bereitstellen der bestimmten Dimensionen der mehreren Räume zur Verwendung mit einem Raumplan des Gebäudes.

8. System nach Anspruch 7, wobei die automatisierten Vorgänge ferner das Erzeugen des Raumplans des Gebäudes auf Basis der visuellen Daten der Mehrzahl von Bildern umfassen, wobei der Raumplan mindestens zweidimensionale Raumformen und relative Positionen der mehreren Räume aufweist, und wobei das Bereitstellen der bestimmten Dimensionen der mehreren Räume das Präsentieren einer visuellen Darstellung des Raumplans mit eingeblendeten Informationen über Dimensionen des Gebäudes aufweist, die auf den bestimmten Dimensionen der mehreren Räume basieren.

9. System nach Anspruch 7, wobei die automatisierten Vorgänge ferner Folgendes aufweisen:
Einsetzen von Außenwänden eines Raumplans für das Gebäude an einem Äußeren des Gebäudes, die in einer Draufsicht des Gebäudes sichtbar sind;
Verwenden von bestimmten Größeninformationen des Äußeren des Gebäudes in der Draufsicht zum Bestimmen von Dimensionen von Wänden der mehreren Räume; und
Bestimmen einer dritten Schätzung der tatsächlichen Kamerahöhe zumindest teilweise auf Basis der bestimmten Dimensionen der Wände der mehreren Räume und von Teilen der visuellen Daten der Mehrzahl von Bildern, die die Wände der mehreren Räume zeigen, einschließlich Verwenden von Informationen über, für jede der Wände der mehreren Räume, Informationen über Positionen von Ecken dieser Wand in der Mehrzahl von Bildern,
und wobei das Überprüfen ferner das Bestimmen aufweist, dass die bestimmte dritte Schätzung der tatsächlichen Kamerahöhe sich von der zusammengesetzten ersten und zweiten geschätzten Kamerahöhe um höchsten den definierten Schwellenwert unterscheidet.

10. System nach Anspruch 7, wobei jedes der Mehrzahl von Bildern ein begradigtes Panoramabild in äquirektangulärem Format ist und wobei das Analysieren der visuellen Daten der Mehrzahl von Bildern zum Ermitteln der mehreren Türdurchgänge und der mehreren Schränke das Verwenden von einem oder mehreren Modellen des maschinellen Lernens aufweist, die zum Ermitteln von Türdurchgängen und Schränken trainiert sind.

11. System nach Anspruch 7, wobei das Bestimmen von mindestens einer von der ersten Schätzung der tatsächlichen Kamerahöhe oder der zweiten Schätzung der tatsächlichen Kamerahöhe das Verwenden von einem oder mehreren Modellen des maschinellen Lernens aufweist, die zum Verwenden visueller Daten von mindestens einem von Türdurchgängen oder Schränken, die auf Fußböden aufgestellt sind, trainiert sind.

12. Verfahren nach Anspruch 7, wobei das Analysieren der visuellen Daten der Mehrzahl von Bildern ferner das Ermitteln mindestens eines zusätzlichen Gegenstands mindestens einer zusätzlichen Gegenstandsart aufweist, wobei die mindestens eine zusätzliche Gegenstandsart mindestens eines von einem Ofen oder einem Geschirrspüler oder einer Herdplatte oder einem Luftaustritt oder einem Ventilatorflügel oder einem Bett oder einem Fernsehgerät oder einer Steckdose oder einer Wandschalterplatte ist, wobei die automatisierten Vorgänge ferner das Bestimmen einer dritten Schätzung der tatsächlichen Kamerahöhe für jede der mindestens einen zusätzlichen Gegenstandsart unter Verwendung visueller Daten von mindestens einem ermittelten zusätzlichen Gegenstand dieser zusätzlichen Gegenstandsart, einschließlich Verwenden von Informationen über, für jeden des mindestens einen ermittelten zusätzlichen Gegenstands dieser zusätzlichen Gegenstandsart, Informationen über Positionen von Ecken dieses ermittelten zusätzlichen Gegenstands in der Mehrzahl von Bildern, und wobei das Bestimmen der endgültigen Schätzung der tatsächlichen Kamerahöhe ferner das Kombinieren der bestimmten dritten Schätzung der tatsächlichen Kamerahöhe für jede der mindestens einen zusätzlichen Gegenstandsart aufweist.

13. Nichtflüchtiges computerlesbares Medium mit gespeichertem Inhalt, der eine oder mehrere Rechenvorrichtungen zum Durchführen von automatisierten Vorgängen zum Umsetzen des Verfahrens nach einem der Ansprüche 1 bis 6 veranlasst.

## Revendications

1. Procédé mis en œuvre par ordinateur comprenant :
obtenir (605), par un ou plusieurs dispositifs informatiques, une pluralité d'images capturées dans des pièces multiples d'un bâtiment par un appareil de caméra positionné à une hauteur réelle de la caméra au-dessus des sols des pièces multiples pendant la capture de la pluralité d'images ;
analyser (610), par l'un ou plusieurs dispositifs informatiques, des données visuelles de la pluralité d'images afin d'identifier de multiples portes et de multiples placards visibles sur les images multiples de la pluralité d'images, les multiples placards étant installés chacun sur le sol de l'une des multiples pièces ;
déterminer (615), par l'un ou plusieurs dispositifs informatiques et pour chacune des multiples portes, une première estimation de la hauteur réelle de la caméra pour l'une ou plusieurs images des images multiples dans laquelle cette porte est visible en utilisant une première hauteur estimée prédéfinie des multiples portes et des informations sur les positions dans cette une ou ces plusieurs images de coins de cette porte, et générer une première hauteur de caméra estimée agrégée de l'appareil de caméra en combinant des premières estimations déterminées de la hauteur réelle de la caméra pour les multiples portes ;
déterminer (615), par l'un ou plusieurs dispositifs informatiques et pour chacun des multiples placards, une deuxième estimation de la hauteur réelle de la caméra pour au moins une image des images multiples dans laquelle ce placard est visible en utilisant une deuxième hauteur estimée prédéfinie des multiples placards et des informations sur les positions dans cette au moins l'une de ces images d'un haut et d'un bas de ce placard, et générer une deuxième hauteur de caméra estimée agrégée de l'appareil de caméra en combinant des deuxièmes estimations déterminées de la hauteur réelle de la caméra pour les multiples placards ;
vérifier (620), par l'un ou plusieurs dispositifs informatiques, que la première et la deuxième hauteur de caméra estimées agrégées de l'appareil de caméra diffèrent d'au plus un degré seuil défini ;
déterminer (630), par l'un ou plusieurs dispositifs informatiques en réponse au fait de vérifier, une estimation finale de la hauteur réelle de la caméra en combinant la première et la deuxième hauteur de caméra estimées agrégées de l'appareil de caméra ;
déterminer (635), par l'un ou plusieurs dispositifs informatiques et sur la base de l'estimation finale déterminée de la hauteur réelle de la caméra et des données visuelles de la pluralité d'images, les dimensions des pièces multiples en attribuant, pour chacune des pièces multiples et pour chacun d'au moins certains murs dans cette pièce, au moins une longueur jusqu'à ce mur de cette pièce en utilisant des informations sur les positions des coins de ce mur de cette pièce dans la pluralité d'images ; et
fournir, par l'un ou plusieurs dispositifs informatiques, les dimensions déterminées des pièces multiples pour utilisation avec un plan d'étage du bâtiment.

2. Procédé mis en œuvre par ordinateur selon la revendication 1, comprenant en outre :
générer le plan d'étage du bâtiment sur la base des données visuelles de la pluralité d'images, le plan d'étage comprenant au moins les formes bidimensionnelles des pièces et les positions relatives des pièces multiples, et dans lequel fournir les dimensions déterminées des pièces multiples comprend présenter une représentation visuelle du plan d'étage avec des informations superposées sur les dimensions du bâtiment qui sont basées sur les dimensions déterminées des pièces multiples.

3. Procédé mis en œuvre par ordinateur selon la revendication 1, comprenant en outre :
placer, par l'un ou plusieurs dispositifs informatiques, des murs extérieurs d'un plan d'étage du bâtiment à un extérieur du bâtiment visible sur une image aérienne du bâtiment ;
utiliser, par l'un ou plusieurs dispositifs informatiques, des informations de taille déterminée de l'extérieur du bâtiment sur l'image aérienne afin de déterminer les dimensions des murs des pièces multiples ; et
déterminer, par l'un ou plusieurs dispositifs informatiques, une troisième estimation de la hauteur réelle de la caméra sur la base en partie au moins des dimensions déterminées des murs des pièces multiples et de parties des données visuelles de la pluralité d'images qui montrent les murs des pièces multiples, y compris en utilisant des informations, pour chacun des murs des pièces multiples, sur les positions des coins de ce mur dans la pluralité d'images,
et dans lequel vérifier comprend en outre déterminer que la troisième estimation déterminée de la hauteur réelle de la caméra diffère de la première et de la deuxième hauteur de caméra estimées agrégées d'au plus le degré seuil défini.

4. Procédé mis en œuvre par ordinateur selon la revendication 1, dans lequel chacune de la pluralité d'images est une image panoramique redressée en format équirectangulaire, et dans lequel analyser les données visuelles de la pluralité d'images pour identifier les multiples portes et les multiples placards comprend utiliser un ou plusieurs modèles d'apprentissage machine entraînés pour identifier des portes et des placards.

5. Procédé mis en œuvre par ordinateur selon la revendication 1, dans lequel déterminer au moins l'une d'entre la première estimation de la hauteur réelle de la caméra ou la deuxième estimation de la hauteur réelle de la caméra comprend utiliser un ou plusieurs modèles d'apprentissage machine entraînés pour utiliser des données visuelles d'au moins l'une des portes ou l'un des placards installés sur les sols.

6. Procédé mis en œuvre par ordinateur selon la revendication 1, dans lequel analyser les données visuelles de la pluralité d'images comprend en outre identifier au moins un objet supplémentaire d'au moins un type d'objet supplémentaire, le au moins un type d'objet supplémentaire étant au moins l'un d'entre un four, ou un lave-vaisselle, ou une plaque électrique, ou une bouche d'aération, ou une pale de ventilateur, ou un lit, ou une télévision, ou une prise électrique, ou une plaque murale d'interrupteur, où le procédé comprend en outre déterminer une troisième estimation de la hauteur réelle de la caméra pour chacun du au moins l'un des types d'objet supplémentaire en utilisant les données visuelles d'au moins un objet supplémentaire identifié de ce type d'objet supplémentaire, y compris en utilisant des informations, pour chacun du au moins un objet supplémentaire identifié de ce type d'objet supplémentaire, sur les positions des coins de cet objet supplémentaire identifié dans la pluralité d'images, et dans lequel déterminer l'estimation finale de la hauteur réelle de la caméra comprend en outre combiner la troisième estimation déterminée de la hauteur réelle de la caméra pour chacun d'au moins l'un des types d'objet supplémentaire.

7. Système comprenant :
un ou plusieurs processeurs matériels d'un ou plusieurs dispositifs informatiques ; et
une ou plusieurs mémoires avec des instructions stockées qui, lorsque exécutées par au moins l'un de l'un ou plusieurs processeurs matériels, font qu'au moins un dispositif informatique de l'un ou plusieurs dispositifs informatiques exécute des opérations automatisées comprenant au moins :
obtenir (605) une pluralité d'images capturées dans des pièces multiples d'un bâtiment par un appareil de caméra positionné à une hauteur réelle de la caméra au-dessus des sols des pièces multiples pendant la capture de la pluralité d'images ;
analyser (610) des données visuelles de la pluralité d'images afin d'identifier de multiples portes et de multiples placards visibles sur les images multiples de la pluralité d'images, les multiples placards étant installés chacun sur le sol de l'une des multiples pièces ;
déterminer (615), pour chacune des multiples portes, une première estimation de la hauteur réelle de la caméra pour l'une ou plusieurs images des images multiples dans laquelle cette porte est visible en utilisant une première hauteur estimée prédéfinie des multiples portes et des informations sur les positions dans cette une ou ces plusieurs images des coins de cette porte, et générer une première hauteur de caméra estimée agrégée de l'appareil de caméra en combinant des premières estimations déterminées de la hauteur réelle de la caméra pour les multiples portes ;
déterminer (615), pour chacun des multiples placards, une deuxième estimation de la hauteur réelle de la caméra pour au moins une image des images multiples dans laquelle ce placard est visible en utilisant une deuxième hauteur estimée prédéfinie des multiples placards et des informations sur les positions dans cette au moins l'une des images d'un haut et d'un bas de ce placard, et générer une deuxième hauteur de caméra estimée agrégée de l'appareil de caméra en combinant des deuxièmes estimations déterminées de la hauteur réelle de la caméra pour les multiples placards ;
vérifier (620) que la première et la deuxième hauteur de caméra estimées agrégées de l'appareil de caméra diffèrent d'au plus un degré seuil défini ;
déterminer (630) en réponse au fait de vérifier, une estimation finale de la hauteur réelle de la caméra en combinant la première et la deuxième hauteur de caméra estimées agrégées de l'appareil de caméra ;
déterminer (635) sur la base de l'estimation finale déterminée de la hauteur réelle de la caméra et des données visuelles de la pluralité d'images, les dimensions des pièces multiples en attribuant, pour chacune des pièces multiples et pour chacun d'au moins certains murs dans cette pièce, au moins une longueur jusqu'à ce mur de cette pièce en utilisant des informations sur les positions des coins de ce mur de cette pièce dans la pluralité d'images ; et
fournir les dimensions déterminées des pièces multiples pour utilisation avec un plan d'étage du bâtiment.

8. Système selon la revendication 7, dans lequel les opérations automatisées comprennent en outre générer le plan d'étage du bâtiment sur la base des données visuelles de la pluralité d'images, le plan d'étage comprenant au moins les formes bidimensionnelles des pièces et les positions relatives des pièces multiples, et dans lequel fournir les dimensions déterminées des pièces multiples comprend présenter une représentation visuelle du plan d'étage avec des informations superposées sur les dimensions du bâtiment qui sont basées sur les dimensions déterminées des pièces multiples.

9. Système selon la revendication 7, dans lequel les informations automatisées comprennent en outre :
placer des murs extérieurs d'un plan d'étage du bâtiment à un extérieur du bâtiment visible sur une image aérienne du bâtiment ;
utiliser des informations de taille déterminée de l'extérieur du bâtiment sur l'image aérienne afin de déterminer les dimensions des murs des pièces multiples ; et
déterminer une troisième estimation de la hauteur réelle de la caméra sur la base en partie au moins des dimensions déterminées des murs des pièces multiples et de parties des données visuelles de la pluralité d'images qui montrent les murs des pièces multiples, y compris en utilisant des informations, pour chacun des murs des pièces multiples, sur les positions des coins de ce mur dans la pluralité d'images,
et dans lequel vérifier comprend en outre déterminer que la troisième estimation déterminée de la hauteur réelle de la caméra diffère de la première et de la deuxième hauteur de caméra estimées agrégées d'au plus le degré seuil défini.

10. Système selon la revendication 7, dans lequel chacune de la pluralité d'images est une image panoramique redressée en format équirectangulaire, et dans lequel analyser les données visuelles de la pluralité d'images pour identifier les multiples portes et les multiples placards comprend utiliser un ou plusieurs modèles d'apprentissage machine entraînés pour identifier des portes et des placards.

11. Système selon la revendication 7, dans lequel déterminer au moins l'une d'entre la première estimation de la hauteur réelle de la caméra ou la deuxième estimation de la hauteur réelle de la caméra comprend utiliser un ou plusieurs modèles d'apprentissage machine entraînés pour utiliser des données visuelles d'au moins l'une des portes ou l'un des placards installés sur les sols.

12. Système selon la revendication 7, dans lequel analyser les données visuelles de la pluralité d'images comprend en outre identifier au moins un objet supplémentaire d'au moins un type d'objet supplémentaire, le au moins un type d'objet supplémentaire étant au moins l'un d'entre un four, ou un lave-vaisselle, ou une plaque électrique, ou une bouche d'aération, ou une pale de ventilateur, ou un lit, ou une télévision, ou une prise électrique, ou une plaque murale d'interrupteur, où le procédé comprend en outre déterminer une troisième estimation de la hauteur réelle de la caméra pour chacun du au moins l'un des types d'objet supplémentaire en utilisant les données visuelles d'au moins un objet supplémentaire identifié de ce type d'objet supplémentaire, y compris en utilisant des informations, pour chacun du au moins un objet supplémentaire identifié de ce type d'objet supplémentaire, sur les positions des coins de cet objet supplémentaire identifié dans la pluralité d'images, et dans lequel déterminer l'estimation finale de la hauteur réelle de la caméra comprend en outre combiner la troisième estimation déterminée de la hauteur réelle de la caméra pour chacun d'au moins l'un des types d'objet supplémentaire.

13. Support non transitoire lisible par ordinateur ayant des contenus stockés qui font qu'un ou plusieurs dispositifs informatiques exécutent les opérations automatisées pour mettre en œuvre le procédé selon l'une quelconque des revendications 1 à 6.
